# EUROPEAN PATENT APPLICATION

(11) **EP 4 668 250 A1**
(43) Date of publication of application: **24.12.2025**
(21) Application number: 24822574.0
(22) Date of filing: 31.05.2024
(51) Int. Cl.: G09F 9/30, H04M 1/02

(54) **SCREEN AND ELECTRONIC DEVICE**

(30) Priority: 14.06.2023 CN 202310708888
(71) Applicant: Huawei Technologies Co., Ltd., Shenzhen, Guangdong 518129 (CN)
(72) Inventor: LIU, Yahao, Shenzhen, Guangdong 518129 (CN); ZHAO, Yangyang, Shenzhen, Guangdong 518129 (CN); RAO, Simin, Shenzhen, Guangdong 518129 (CN); ZHANG, Rui, Shenzhen, Guangdong 518129 (CN); FENG, Yanbin, Shenzhen, Guangdong 518129 (CN); HU, Zhandi, Shenzhen, Guangdong 518129 (CN); CHEN, Bao, Shenzhen, Guangdong 518129 (CN); YAO, Xilin, Shenzhen, Guangdong 518129 (CN); LUO, Yang, Shenzhen, Guangdong 518129 (CN)
(74) Representative: Isarpatent
(86) International application number: PCT/CN2024/096859
(87) International publication number: WO 2024/255622

(57) **Abstract**

This application discloses a display and an electronic device. The display includes a display screen and a reinforcing plate. The display screen includes a first screen part and a second screen part. The second screen part fully or half surrounds the first screen part. The first screen part includes a first outer surface and a first inner surface that are disposed back to back. The second screen part includes a second outer surface and a second inner surface that are disposed back to back. The first outer surface is flush with the second outer surface, and the first inner surface is recessed relative to the second inner surface to form a groove. The reinforcing plate is located on a side that is of the first inner surface and that is away from the first outer surface, and the reinforcing plate and the first screen part are stacked. The reinforcing plate is at least partially located in the groove and is fastened to the display screen. At least a partial region of the first screen part allows external light to pass through, at least a partial region of the reinforcing plate allows external light to pass through, and external light is capable of passing through the first screen part and the reinforcing plate and entering non-display side space of the display. The display has a region with a high transmittance, and reliability of the display is high.

## Description

This application claims priority to Chinese Patent Application No. 202310708888.3, filed with the China National Intellectual Property Administration on June 14, 2023 and entitled "DISPLAY AND ELECTRONIC DEVICE", which is incorporated herein by reference in its entirety.

### TECHNICAL FIELD

Embodiments of this application relate to the field of display device technologies, and in particular, to a display and an electronic device.

### BACKGROUND

An electronic device (for example, a notebook computer or a mobile phone) may include a display and a front-facing camera. The display is used to display an image, and the front-facing camera is used to shoot a scene in front of the display. To obtain large screen-to-body ratios, in more electronic devices, front-facing cameras are placed under displays to form under-display camera structures.

Currently, two solutions may be generally used for the under-display camera structure. A first solution is that a display structure is complete, a partial region of the display forms a light transmission region, and the front-facing camera is placed under the light transmission region. In this solution, because all stack layers of the display are reserved in the light transmission region of the display, and a thickness is large, a transmittance of the light transmission region is low. Consequently, image shooting effect of the front-facing camera is dark, and imaging quality is poor. A second solution is to dig a light through hole in the display, and place the front-facing camera under the light through hole. In this solution, although the front-facing camera collects light in front of the display through the light transmission hole, and better imaging quality can be obtained, disposing of the light transmission hole causes a decrease in structural strength of the display. Especially for a bendable flexible display, structural strength of the display at a light transmission hole and a surrounding location is obviously reduced. Consequently, the display is likely to be damaged when being pressed or impacted by an external force, and reliability of the display is poor.

Therefore, how the display obtains a high-transmittance area and has high reliability becomes an urgent problem that needs to be resolved.

### SUMMARY

An embodiment of this application provides a display and an electronic device. The display has a region with a high transmittance, and reliability of the display is high.

According to a first aspect, an implementation of this application provides a display, which may be used in an electronic device. The electronic device includes an optical device located on a non-display side of the display. The display includes a display screen and a reinforcing plate. The display screen includes a first screen part and a second screen part, and the second screen part fully or half surrounds the first screen part. The second screen part is connected to the first screen part. The first screen part and the second screen part may be an integrally formed mechanical part.

The first screen part includes a first outer surface and a first inner surface that are disposed back to back, the second screen part includes a second outer surface and a second inner surface that are disposed back to back, the first outer surface is flush with the second outer surface, and the first inner surface is recessed relative to the second inner surface to form a groove. A thickness of the first screen part is less than a thickness of the second screen part.

The second screen part of the display screen is configured to display an image. The second screen part of the display screen may have a conventional display structure, and the conventional display structure corresponds to a fully stacking structure of the display screen. Compared with the second screen part, the first screen part of the display screen may obtain a smaller quantity of stack layers and a smaller thickness by reducing some stack layers and reserving some stack layers.

The reinforcing plate is located on a side that is of the first inner surface and that is away from the first outer surface, and the reinforcing plate and the first screen part are stacked. The reinforcing plate is at least partially located in the groove and is fastened to the display screen. At least a partial region of the first screen part allows external light to pass through, and at least a partial region of the reinforcing plate allows external light to pass through. External light is capable of passing through the first screen part and the reinforcing plate and entering non-display side space of the display.

A region that is of the first screen part and that allows external light to pass through is a light transmission region of the first screen part. A region that is of the reinforcing plate and that allows external light to pass through is a light transmission region of the reinforcing plate. In some implementations, the light transmission region of the reinforcing plate and the light transmission region of the first screen part are disposed directly opposite to each other. In a thickness direction of the display, there is an overlapping region between the light transmission region of the reinforcing plate and the light transmission region of the first screen part. External light sequentially passes through the light transmission region of the first screen part and the light transmission region of the reinforcing plate, and enters the non-display side space of the display.

In an implementation of this application, a light transmission region of the display is disposed corresponding to the light transmission region of the first screen part and the light transmission region of the reinforcing plate, to obtain a high transmittance. Because the reinforcing plate and the first screen part are stacked, the reinforcing plate can increase structural strength of the first screen part, to increase structural strength of the display screen at the groove. So when the display is externally pressed, squeezed, or impacted, there is a low risk of deformation or damage, and the display has high reliability. In addition, because the reinforcing plate is at least partially located in the groove, a gap between the reinforcing plate and the first screen part is small. When the first screen part is squeezed or pressed, deformation space in the thickness direction of the display is small, so that reinforcing effect of the reinforcing plate on the first screen part is better.

In the thickness direction of the display, the light transmission region of the first screen part completely covers the light transmission region of the display, and the light transmission region of the reinforcing plate completely covers the light transmission region of the display, so that the light transmission region of the display has a high overall transmittance, and an optical path environment is consistent or similar. In this way, lighting quality of the optical device located below the light transmission region of the display is better.

In some implementations, there may be one or more stack layers of the first screen part of the display screen, and most or all of the stack layers of the first screen part may be stack layers with high transmittances. In this case, the transmittance of the first screen part is high, so that a transmittance of the light transmission region of the display is high, to help improve the lighting quality of the optical device of the electronic device. For example, transmittances of all or most of the stack layers of the first screen part may be greater than or equal to 20%, for example, 45%, 68%, 80%, 85%, 91%, 93% or 98%.

In some possible implementations, the display screen includes a first stack layer and a second stack layer, the first stack layer is located on the first screen part and the second screen part, the second stack layer is located on the second screen part, and a transmittance of the first stack layer is higher than a transmittance of the second stack layer. In other words, in comparison with the second screen part, the first screen part reserves the first stack layer with a high transmittance and reduces the second stack layer with a low transmittance. For example, the transmittance of the first stack layer is higher than 20%, and the transmittance of the second stack layer is lower than 20%.

In this implementation, a stack layer with a low transmittance is reduced and a stack layer with a high transmittance is reserved for the first screen part, to help improve an overall transmittance. The first stack layer is one of stack layers reserved for the first screen part, and the second stack layer is one of stack layers reduced by the first screen part in comparison with the second screen part. In this implementation of this application, all stack layers reduced for the first screen part relative to the second screen part are not limited to stack layers with low transmittances, or may include some stack layers with high transmittances, and all the stack layers of the first screen part are not limited to stack layers with high transmittances, it is also allowed that the first screen part includes a stack layer with a low transmittance for implementing another function.

In some possible implementations, a transmittance of the reinforcing plate is higher than the transmittance of the second stack layer. For example, a transmittance of the region that is of the reinforcing plate and that allows external light to pass through is higher than the transmittance of the second stack layer. In this implementation, the transmittance of the reinforcing plate is higher than the transmittance of the stack layer reduced by the first screen part, so that an overall transmittance of a stacking structure of the first screen part and the reinforcing plate is higher than a transmittance of the second screen part. In this way, a light transmission region located on the stacking structure has a high transmittance. This helps improve lighting quality of the optical device.

In some implementations, the reinforcing plate is of a flat plate structure. The reinforcing plate includes a first plate surface, a second plate surface, and a peripheral side surface. The first plate surface and the second plate surface are disposed back to back and are parallel to each other, and the peripheral side surface is connected to the first plate surface and the second plate surface in an encircling manner. The first plate surface of the reinforcing plate is disposed facing the first screen part, and the second plate surface is disposed away from the first screen part. In this implementation, the reinforcing plate has a simple structure, is easy to process, and has low costs.

For example, the reinforcing plate is parallel to the first screen part. Specifically, both the first plate surface and the second plate surface of the reinforcing plate are parallel to the first outer surface of the first screen part. In this case, distortion of external light in a process of passing through the first screen part and the reinforcing plate is slight, so that the optical device can collect high-quality external light through the light transmission region of the display. For example, when the optical device is a camera module, image shooting quality of the camera module is good.

For example, a main structure of the reinforcing plate is a plate body. The plate body of the reinforcing plate may be made of a material with a high transmittance and high structural strength. The transmittance of the plate body of the reinforcing plate may be adjusted based on a lighting requirement of the optical device. For example, a transmittance of the plate body of the reinforcing plate is greater than or equal to 20%, for example, 40%, 65%, 83%, 85%, 91%, 93% or 96%. In some examples, the transmittance of the plate body of the reinforcing plate may be greater than or equal to 80%, to help external light pass through the light transmission region of the display, so as to increase an amount of light received by the camera module. In this way, imaging quality of the camera module is high, and a risk of occurrence of stray light and ghosting is reduced.

For example, the plate body of the reinforcing plate may be made of a polymer material or optical glass. For example, a material of the plate body of the reinforcing plate may be transparent plastic, for example, a polyethylene terephthalate material, a polycarbonate material, a colorless polyimide material, a cyclo olefin polymer material, or a triacetyl cellulose material, or a material of the plate body of the reinforcing plate may be ultra thin glass.

In some possible implementations, in a plane direction of the display, an opening area of the groove is a first area, a part that is of the reinforcing plate and that is located in the groove has a second area, and a ratio of the second area to the first area is greater than or equal to 80%.

In this implementation, because the ratio of the area of the part that is of the reinforcing plate and that is located in the groove to the opening area of the groove is greater than or equal to 80%, the area of the part that is of the reinforcing plate and that is located in the groove is large, so that the first screen part can be better supported, and reliability of the display is improved. In addition, because an area of the reinforcing plate is large, it is helpful to ensure that external light can pass through the reinforcing plate when entering the non-display side space of the display through the light transmission region of the display, and an optical path environment is consistent or similar, so that an image collected by the optical device has a lower risk of distortion, and lighting quality of the optical device is improved.

In some possible implementations, the display further includes a bonding member, the bonding member is located between the reinforcing plate and the first inner surface and is fastened to the reinforcing plate and the first inner surface, and the bonding member allows external light to pass through. In this case, the bonding member is fastened to the first plate surface of the reinforcing plate. The reinforcing plate is fastened to the first inner surface of the first screen part through stacking. The reinforcing plate can directly reinforce the first screen part with a good reinforcing effect. In addition, the reinforcing plate and the first screen part are compactly arranged, to help control a thickness of the light transmission region of the display, so that when a location of the optical device is a bottleneck of an overall thickness of the electronic device, the overall thickness of the electronic device can be effectively controlled. This helps implement thinning of the electronic device.

The bonding member may be made of a material with a high light transmittance. For example, a transmittance of the bonding member may be greater than or equal to 20%, for example, 40%, 65%, 83%, 85%, 91%, 93% or 96%. In some examples, the transmittance of the bonding member is greater than or equal to 80%. For example, a bonding adhesive may be an optically clear adhesive or a pressure-sensitive adhesive.

In some possible implementations, a surface that is of the second screen part and that faces the groove is a side wall of the groove, and a gap is formed between the peripheral side surface of the reinforcing plate and the side wall of the groove.

In this implementation, the gap between the peripheral side surface of the reinforcing plate and the side wall of the groove is an assembly gap. Disposing the assembly gap can reduce a risk of damage caused by the reinforcing plate to the display screen, to protect the display screen.

In some possible implementations, the display screen includes a light shielding layer, and the light shielding layer is annular. The light shielding layer is at least partially located on the first screen part. In the thickness direction of the display, the light shielding layer covers the gap and a periphery of the reinforcing plate, and exposes a middle part of the reinforcing plate. The light shielding layer may be made of a light absorbing material or a light blocking material. For example, the light shielding layer may be an ink layer.

In this implementation, the light shielding layer shields the gap between the reinforcing plate and the side wall of the groove, and the periphery of the reinforcing plate, so that appearance effect of the display can be improved. In addition, the light shielding layer can further absorb stray light, to reduce stray light entering a lighting path of the optical device, so as to improve lighting quality of the optical device. The stray light may be, but is not limited to, light emitted by the display screen, or light emitted by a component like a flash in the electronic device.

In some possible implementations, the reinforcing plate includes a plate body and a light barrier layer. The light barrier layer is fastened to a plate surface that is of the plate body and that is away from the first screen part. A transmittance of the plate body is greater than or equal to 20%. The light barrier layer may be made of a light absorbing material or a light blocking material to block an optical path. For example, the light barrier layer may be an ink layer, and the ink layer may be formed by directly coating ink on the plate surface of the plate body. Alternatively, the light barrier layer may be a black film, and the black film may be fastened to the plate surface of the plate body through bonding or the like.

The light barrier layer may be annular, an inner diameter of the light barrier layer is less than an inner diameter of the light shielding layer, an outer diameter of the light barrier layer is greater than the inner diameter of the light shielding layer, and intra-annular space of the light barrier layer is directly opposite to intra-annular space of the light shielding layer.

In this implementation, the plate surface that is of the plate body of the reinforcing plate and that is away from the first screen part is close to the non-display side of the display, and is accordingly close to the optical device located on the non-display side of the display. Therefore, a distance between the light barrier layer located on the plate surface that is of the plate body and that is away from the first screen part and the optical device is small, and a size of the inner diameter of the light barrier layer may be set to a small size based on a light-receiving field of view characteristic of the optical device, so that a size of the outer diameter of the light barrier layer may be small, a size of the outer diameter of the reinforcing plate may be small, and an opening size of the groove of the display screen may be small. This helps reduce an area of a non-display region of the display, and helps increase a screen-to-body ratio of the display.

The light shielding layer may shield the gap between the reinforcing plate and the side wall of the groove, to shield a light barrier structure difference like an ink difference at an edge of the reinforcing plate, so as to improve appearance effect of the display.

In some possible implementations, the reinforcing plate includes the plate body and a light blocking layer, and the light blocking layer covers a peripheral side surface of the plate body. The light blocking layer may be made of a light absorbing material or a light blocking material, to block an optical path. For example, the light blocking layer may be an ink layer, and the ink layer may be formed by directly coating ink on the peripheral side surface of the plate body. Alternatively, the light blocking layer may be a black film, and the black film may be fastened to the peripheral side surface of the plate body through bonding or the like.

In this implementation, the light blocking layer of the reinforcing plate is disposed facing the side wall of the groove. The light blocking layer may absorb stray light or block propagation of stray light, to reduce stray light entering a lighting path of the optical device, and reduce a risk of light crosstalk, so as to improve lighting quality of the optical device. The stray light may be, but is not limited to, light emitted by the display screen, or light emitted by a component like a flash in the electronic device.

In some possible implementations, in the thickness direction of the display, a sum of the thickness of the reinforcing plate and a thickness of the bonding member is equal to a depth of the groove. In this case, the second plate surface of the reinforcing plate is flush with the second inner surface of the second screen part, and disposing of the reinforcing plate does not increase the thickness of the display. This facilitates thinning of the electronic device, and flattens an inner surface of the display to help reduce assembly difficulty of the display, and simplify an assembly structure of the display.

In some possible implementations, in the thickness direction of the display, a sum of the thickness of the reinforcing plate and a thickness of the bonding member is less than a depth of the groove. In this case, the second plate surface of the reinforcing plate is recessed relative to the second inner surface of the second screen part, and disposing of the reinforcing plate does not increase the thickness of the display. This facilitates thinning of the electronic device.

In some possible implementations, the reinforcing plate includes a first plate body and a second plate body, and the second plate body is fastened to a middle part of the first plate body. The first plate body is a part of the plate body, the second plate body is the other part of the plate body, and the first plate body and the second plate body may be stacked. The first plate body and the second plate body may be an integrally formed mechanical part. A transmittance of the first plate body and a transmittance of the second plate body are both greater than or equal to 20%.

The second plate body is at least partially located in the groove, the first plate body is located outside the groove, and a periphery of the first plate body is fastened to the second screen part. For example, the periphery of the first plate body may be bonded to the second screen part through the adhesive layer.

In this implementation, the light transmission region of the display may be disposed corresponding to the first screen part, the middle part of the first plate body, and the middle part of the second plate body, and the light transmission region has a high transmittance, so that the optical device on the non-display side of the display implements lighting. Because the first plate body and the second plate body are stacked with the first screen part, and the second plate body is at least partially located in the groove, the reinforcing plate may increase structural strength of the first screen part and a surrounding location of the first screen part, so that structural reliability of the display is improved. In addition, because the reinforcing plate is fastened to the second screen part, which is thick enough to provide a more reliable fastening structure and a more reliable supporting force, so that the reinforcing plate and the display screen have a more stable and reliable assembly structure.

In some examples, the transmittance of the plate body of the reinforcing plate may be greater than or equal to 80%, to help external light pass through the light transmission region of the display, so as to increase an amount of light received by the camera module. In this way, imaging quality of the camera module is high, and a risk of occurrence of stray light and ghosting is reduced. Materials of the first plate body and the second plate body may be polymer materials or optical glass.

In some possible implementations, a surface that is of the second screen part and that faces the groove is a side wall of the groove, and a gap is formed between a peripheral side surface of the second plate body and the side wall of the groove. In this implementation, the gap between the peripheral side surface of the second plate body and the side wall of the groove is an assembly gap. Disposing the assembly gap can reduce a risk of damage caused by the reinforcing plate to the display screen, to protect the display screen.

The reinforcing plate further includes a light barrier layer, and the light barrier layer is annular. The light barrier layer is fastened to a periphery of a surface that is of the first plate body and that is away from the second plate body. In the thickness direction of the display, the light barrier layer covers the gap and a periphery of the second plate body. The light barrier layer may be made of a light absorbing material or a light blocking material to block an optical path. For example, the light barrier layer may be an ink layer, and the ink layer may be formed by directly coating ink on the second plate surface. Alternatively, the light barrier layer may be a black film, and the black film may be fastened to the second plate surface through bonding or the like.

In this implementation, the light barrier layer shields the gap between the reinforcing plate and the side wall of the groove, and the periphery of the second plate body, so that appearance effect of the display can be improved. In addition, the light barrier layer can further absorb stray light, to reduce stray light entering a lighting path of the optical device, so as to improve lighting quality of the optical device. The stray light may be, but is not limited to, light emitted by the display screen, or light emitted by a component like a flash in the electronic device.

In addition, the light barrier layer is fastened to the periphery of the surface that is of the first plate body and that is away from the second plate body. The light barrier layer is close to the non-display side of the display, and is accordingly close to the optical device located on the non-display side of the display. Therefore, a distance between the light barrier layer and the optical device is small, and a size of an inner diameter of the light barrier layer may be set to a small size based on a light-receiving field of view characteristic of the optical device, so that a size of an outer diameter of the light barrier layer may be small, a size of an outer diameter of the reinforcing plate may be small, and an opening size of the groove of the display screen may be small. This helps increase a screen-to-body ratio of the display.

In some possible implementations, the reinforcing plate further includes a light blocking layer, and the light blocking layer covers at least a region that is on a peripheral side surface of the second plate body and that is located in the groove. For example, the light blocking layer may cover the peripheral side surface of the second plate body. The light blocking layer may be made of a light absorbing material or a light blocking material, to block an optical path. For example, the light blocking layer may be an ink layer, and the ink layer may be formed by directly coating ink on the peripheral side surface of the second plate body. Alternatively, the light blocking layer may be a black film, and the black film may be fastened to the peripheral side surface of the second plate body through bonding or the like.

In this implementation, the light blocking layer of the reinforcing plate is disposed facing the side wall of the groove. The light blocking layer may absorb stray light or block propagation of stray light, to reduce stray light entering a lighting path of the optical device, and reduce a risk of light crosstalk, so as to improve lighting quality of the optical device. The stray light may be, but is not limited to, light emitted by the display screen, or light emitted by a component like a flash in the electronic device.

In some possible implementations, the reinforcing plate may include a light transmission part and a light shielding part, and a transmittance of the light transmission part is higher than a transmittance of the light shielding part. The light transmission part is configured to allow external light to pass through, and the light shielding part is configured to block external light. The light shielding part is disposed around the light transmission part and is fastened to a peripheral side surface of the light transmission part.

A transmittance of the light shielding part may be less than 20%, and a transmittance of the light transmission part may be greater than or equal to 20%. The light shielding part and the light transmission part may be an integrally formed mechanical part, for example, may be formed by using a process like dual-color injection molding.

In some implementations, the light shielding part may absorb stray light or block propagation of the stray light, to reduce stray light entering a lighting path of the optical device, and improve lighting quality of the optical device.

According to a second aspect, an implementation of this application further provides an electronic device, including a housing, an optical device, and the display according to any one of the foregoing implementations. The display is mounted on the housing, the optical device is mounted on the housing and is located on the non-display side of the display, and the optical device is configured to collect external light that passes through the first screen part and the reinforcing plate.

In this implementation, the light transmission region of the display has a high transmittance. Therefore, imaging quality of the camera module is high. The reinforcing plate of the display increases structural strength of the first screen part. So when the first screen part is externally pressed or impacted, there is a low risk of deformation or damage, and the optical device has a lower risk of damage, so that reliability of the electronic device is improved.

In some possible implementations, the electronic device further includes a support member, and the support member abuts between the reinforcing plate and the housing.

In this implementation, because the support member abuts between the reinforcing plate and the housing, the housing may indirectly support the reinforcing plate through the support member, to support the first screen part, so that the first screen part has a lower risk of deformation or damage when externally pressed or impacted. In this way, the display and the electronic device achieve higher reliability.

The support member may be made of an elastic material, to have a supporting and buffering function. For example, the support member may be made of a material like foam, glue, or an adhesive tape. In this case, the support member may further absorb an assembly tolerance between the display and the housing in an assembly process of the electronic device, to improve a yield of the electronic device. A thickness of the support member may be within a range of 0.1 mm to 0.2 mm.

In some possible implementations, the support member is disposed around a collection surface of the optical device. For example, the support may be approximately annular. In this implementation, because the support member is disposed around the incident surface of the optical device, disposing of the support member does not affect lighting of the optical device. In addition, a support region of the support member for the reinforcing plate is annular, and the support region is arranged evenly on a periphery of the reinforcing plate, so that the reinforcing plate is not prone to problems such as tilting and warping. In this way, the first screen part can be reinforced, and consistency of an optical path of the light transmission region of the display can be ensured.

In some possible implementations, the support member is disposed around the collection surface of the optical device, and the support member is connected to the reinforcing plate and the housing through sealing. In this case, the support member can seal a gap between the housing and the reinforcing plate, to seal a gap between the optical device and the reinforcing plate, so as to reduce a risk that dust falls into the incident surface of the optical device, and achieve a dust-proof effect.

In some possible implementations, the supporting member abuts between the second screen part and the housing. In this case, the housing may indirectly support the second screen part through the support member, to further reduce the risk of deformation or damage of the display when the display is externally pressed or impacted. In this way, reliability of the display and the electronic device is higher.

### BRIEF DESCRIPTION OF DRAWINGS

FIG. 1 is a diagram of a structure of an electronic device in a fully open state according to an embodiment of this application;
FIG. 2 is a diagram of a structure of the electronic device shown in FIG. 1 in a partially open state;
FIG. 3 is a diagram of a structure of the electronic device shown in FIG. 1 in a closed state;
FIG. 4 is a diagram of a structure of a display of the electronic device shown in FIG. 1 according to some embodiments;
FIG. 5 is a diagram of a cross-sectional structure of the display shown in FIG. 4 cut along A-A;
FIG. 6 is an enlarged diagram of a structure of the display shown in FIG. 4 at a location B;
FIG. 7 is a diagram of a partial structure of a display shown in FIG. 1 according to some other embodiments;
FIG. 8 is a partial diagram of an internal structure of a display of the electronic device shown in FIG. 1 according to some other embodiments;
FIG. 9 is a diagram of a partial structure of the display shown in FIG. 4 from another perspective;
FIG. 10 is a diagram of a partial structure of the display shown in FIG. 8 from another perspective;
FIG. 11 is a diagram of a structure of a display screen shown in FIG. 5 in some examples;
FIG. 12 is a diagram of a structure of a display screen shown in FIG. 5 in some other examples;
FIG. 13 is a diagram of an internal structure of a second part of a display panel of the display screen shown in FIG. 12;
FIG. 14 is a partial diagram of an internal structure of a display of the electronic device shown in FIG. 1 according to some other embodiments;
FIG. 15 is a partial diagram of an internal structure of a display of the electronic device shown in FIG. 1 according to some other embodiments;
FIG. 16 is a partial diagram of an internal structure of a display of the electronic device shown in FIG. 1 according to some other embodiments;
FIG. 17 is a diagram of a structure of a reinforcing plate of the display shown in FIG. 16;
FIG. 18 is a diagram of a structure of the reinforcing plate shown in FIG. 17 from another perspective;
FIG. 19 is a partial diagram of an internal structure of a display of the electronic device shown in FIG. 1 according to some other embodiments;
FIG. 20 is a diagram of a structure of a reinforcing plate shown in FIG. 19 from another perspective;
FIG. 21 is a diagram of a cross-sectional structure of the electronic device shown in FIG. 1 cut along C-C according to some embodiments;
FIG. 22 is a diagram of a cross-sectional structure of the electronic device shown in FIG. 1 cut along C-C according to some other embodiments;
FIG. 23 is a diagram of a cross-sectional structure of the electronic device shown in FIG. 1 cut along C-C according to some other embodiments;
FIG. 24 is a diagram of a cross-sectional structure of the electronic device shown in FIG. 1 cut along C-C according to some other embodiments; and
FIG. 25 is a diagram of a structure of a display shown in FIG. 24 from another perspective.

### DESCRIPTION OF EMBODIMENTS

The following describes technical solutions of embodiments of this application with reference to accompanying drawings.

In descriptions of embodiments of this application, unless otherwise explicitly specified and limited, the term "and/or" in this specification describes only an association relationship for describing associated objects and represents that three relationships may exist. For example, A and/or B may represent the following three cases: only A exists, both A and B exist, and only B exists. "First", "second", and the like are used only for description purposes, and cannot be understood as implying or implying relative importance or implicitly indicating a quantity of technical features. Therefore, a feature limited by "first" or "second" may explicitly or implicitly include one or more features. "A plurality of" refers to two or more than two.

For example, "mounting" and "connection" should be understood broadly. For example, "connection" may be a non-detachable connection or may be a direct connection or an indirect connection through an intermediate. An "integrally formed mechanical part" means that one part of the mechanical part is connected to another naturally while the mechanical part is forming, without any need of reprocessing (such as bonding, welding, or clamping).

Orientation terms mentioned in embodiments of this application, for example, "up", "down", "inside", and "outside", are merely directions with reference to the accompanying drawings. Therefore, the orientation terms are used to better and more clearly describe and understand embodiments of this application, instead of indicating or implying that a specified apparatus or element should have a specific orientation, and be constructed and operated in the specific orientation. Therefore, this cannot be understood as a limitation on embodiments of this application.

Embodiments of this application provide a display and an electronic device including the display. The display includes a display screen and a reinforcing plate. The display screen includes a first screen part and a second screen part, and the second screen part fully or half surrounds the first screen part. A thickness of the first screen part is less than a thickness of the second screen part, and an inner side of the first screen part is recessed relative to the second screen part to form a groove. The reinforcing plate and the first screen part of the display screen are stacked, and the reinforcing plate is at least partially located in the groove. At least a partial region of the first screen part allows external light to pass through, at least a partial region of the reinforcing plate allows external light to pass through, and external light is capable of passing through the first screen part and the reinforcing plate and entering non-display side space of the display.

In embodiments of this application, a light transmission region of the display corresponds to the first screen part of the display screen and a part that is of the reinforcing plate and that allows external light to pass through, and has a high transmittance. In addition, the reinforcing plate can increase structural strength of the display screen at the groove, to improve reliability of the display. Therefore, the display in embodiments of this application may have high reliability when there is a light transmission region with a high transmittance.

The electronic device may be an electronic product having a display function, for example, a mobile phone, a notebook computer, a tablet computer, or a wearable device. The wearable device may be a smartwatch, a smart band, smart glasses, or the like.

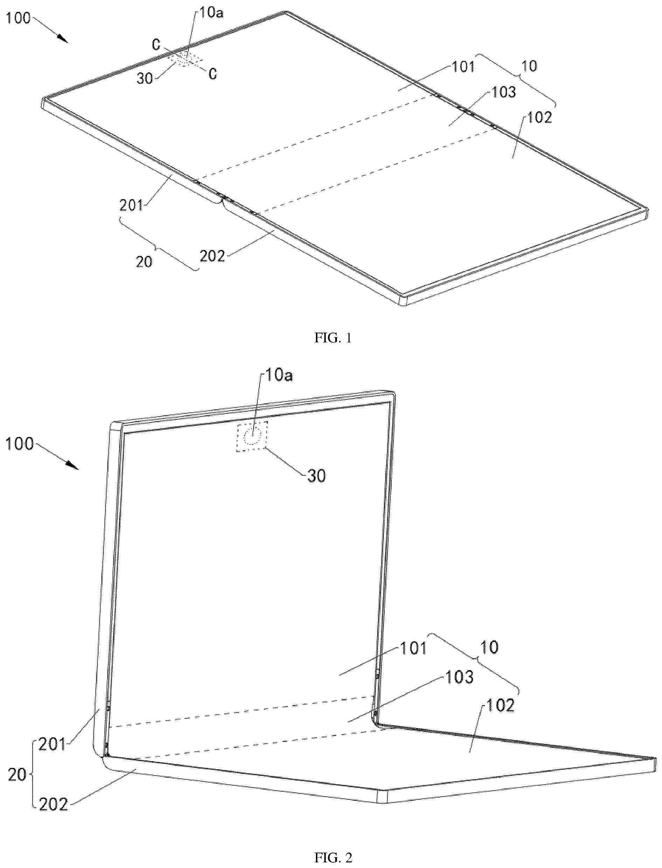

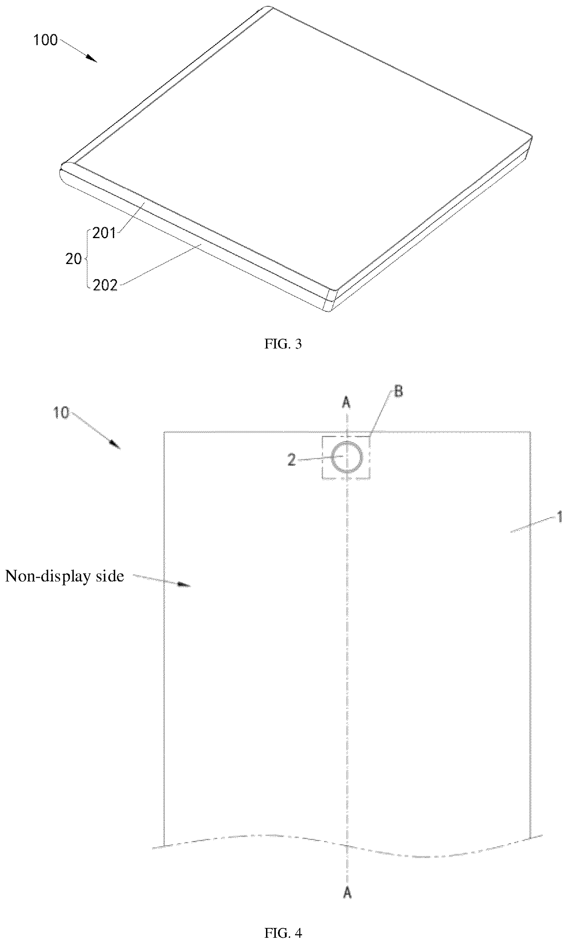

FIG. 1 is a diagram of a structure of an electronic device 100 in a fully open state according to an embodiment of this application. FIG. 2 is a diagram of a structure of the electronic device 100 shown in FIG. 1 in a partially open state. FIG. 3 is a diagram of a structure of the electronic device 100 shown in FIG. 1 in a closed state. The electronic device 100 in this embodiment of this application is described by using a foldable mobile phone as an example. Certainly, another type of electronic device may also use a similar structure. Details are not described again below. It should be noted that FIG. 1 and the following related accompanying drawings schematically show only some components included in the electronic device 100. Actual shapes, actual sizes, actual locations, and actual structures of these components are not limited to those in FIG. 1 and the following accompanying drawings.

In some embodiments, as shown in FIG. 1 to FIG. 3, the electronic device 100 may include a display 10 and a housing 20. For example, the housing 20 may include a first enclosure part 201, a second enclosure part 202, and a rotating shaft (not marked in the figure), and the rotating shaft is connected to the first enclosure part 201 and the second enclosure part 202. Through movement of the rotating shaft, the first enclosure part 201 and the second enclosure part 202 may be unfolded relative to each other to a fully open state or folded relative to each other to a closed state, or may be unfolded or folded relative to each other to a partially open state. The first enclosure part 201 may include a first middle frame, and the second enclosure part 202 may include a second middle frame. In some examples, the first enclosure part 201 may further include a first back cover, and the first back cover may be fastened to a side that is of the first middle frame and that is away from the display 10. The second enclosure part 202 may further include a second back cover, and the second back cover may be fastened to a side that is of the second middle frame and that is away from the display 10.

For example, the display 10 is mounted on the housing 20. The display 10 has a display function, or the display 10 may integrate a display function and a touch sensing function. The display function of the display 10 is used to display a text, an image, a video, and the like. The touch sensing function of the display 10 is used to detect a touch action of a user, to implement human-machine information interaction. The display 10 has a display side and a non-display side that are disposed back to back, and the display side of the display 10 is a side on which the display 10 emits light to implement display. In this embodiment, the display side of the display 10 faces the outside of the electronic device 100, and the non-display side of the display 10 faces the inside of the electronic device 100.

The display 10 may be a bendable flexible display, to deform along with the housing 20. For example, the display 10 may include a first part 101, a second part 102, and a third part 103. The third part 103 is connected between the first part 101 and the second part 102. In other words, the first part 101, the third part 103, and the second part 102 are sequentially arranged. The first part 101 may be fastened to the first enclosure part 201, and the second part 102 may be fastened to the second enclosure part 202. In a process in which the first enclosure part 201 and the second enclosure part 202 are unfolded or folded relative to each other, the first enclosure part 201 drives the first part 101 to move, the second enclosure part 202 drives the second part 102 to move, and the third part 103 deforms under driving of the first part 101, the second part 102, and the housing 20.

As shown in FIG. 1, the first enclosure part 201 and the second enclosure part 202 may be unfolded relative to each other to the fully open state, both the housing 20 and the electronic device 100 are in the fully open state, and the display 10 is unfolded along with the housing 20. For example, when the housing 20 is in the fully open state, an included angle between the first enclosure part 201 and the second enclosure part 202 is 100°, 120°, 150°, 165°, or 180°. In this embodiment of this application, an example in which the included angle between the first enclosure part 201 and the second enclosure part 202 is 180° is used for description. In this case, the display 10 is in an unfolded state, and the first part 101, the third part 103, and the second part 102 of the display 10 are located on a same plane.

As shown in FIG. 3, the first enclosure part 201 and the second enclosure part 202 may be folded relative to each other to the closed state, so that both the housing 20 and the electronic device 100 are in the closed state, and the display 10 is folded along with the housing 20. For example, when the housing 20 is in the closed state, the display 10 may be located between the first enclosure part 201 and the second enclosure part 202, that is, the display 10 may be wrapped by the housing 20. In FIG. 3, because the display 10 is blocked by the housing 20, the display 10 is not marked. It may be understood that, when the first enclosure part 201 and the second enclosure part 202 are in the closed state, the included angle between the first enclosure part 201 and the second enclosure part 202 may be approximately 0°. When the display 10 is in a closed state, the first part 101 and the second part 102 of the display 10 are disposed opposite to each other, and may partially abut against each other, or may completely abut against each other, or have a small gap. The third part 103 is in a completely bent state.

As shown in FIG. 2, the first enclosure part 201 and the second enclosure part 202 may alternatively be unfolded or folded relative to each other to the partially open state, so that both the housing 20 and the electronic device 100 are in the partially open state. The partially open state may be any state between the fully open state and the closed state, and the display 10 also changes accordingly. When the display 10 is in a partially open state, an included angle is formed between the first part 101 and the second part 102 of the display 10, and the third part 103 of the display 10 is in a partially bent state.

In this embodiment, the display 10 can be unfolded or folded along with the housing 20. When the electronic device 100 is in the fully open state, the display 10 is in the unfolded state, and the display 10 can perform full-screen display, so that the electronic device 100 has a large display area, to improve viewing experience and operation experience of the user. When the electronic device 100 is in the closed state, a plane size of the electronic device 100 is small, so that it is convenient for the user to carry and store the electronic device 100. When the electronic device 100 is in the partially open state, a partial region of the display 10 is bent, so that viewing requirements of the user for different viewing angles can be met.

In some embodiments, as shown in FIG. 1 and FIG. 2, the electronic device 100 may further include an optical device 30, and the optical device 30 is mounted on the housing 20. The optical device 30 may be located on the non-display side of the display 10, and is configured to collect external light passing through the display 10. In this embodiment of this application, the optical device 30 is disposed under the display 10 to form an under-display lighting structure, so that the display 10 can have a large display area, to obtain a high screen-to-body ratio. External light is light outside the electronic device 100. For example, external light may include light propagated outside the electronic device 100. In some embodiments, external light may alternatively include light formed after light emitted by the electronic device 100 is reflected or refracted by an external structure or environment of the electronic device 100.

For example, the optical device 30 may be a camera module. The display 10 is provided with a light transmission region 10a that allows external light to pass through, and the light transmission region 10a may be located on the first part 101 of the display 10. In some examples, the camera module may be mounted on the first enclosure part 201, and the camera module is located on the non-display side of the first part 101 of the display 10, and is disposed directly opposite to the light transmission region 10a of the display 10. The camera module is configured to collect external light that passes through the light transmission region 10a of the display 10, to implement imaging. An end that is of the first enclosure part 201 and that is away from the second enclosure part 202 is a top of the first enclosure part 201. The camera module may be mounted at a middle location or either of two corners of the top of the first enclosure part 201. The light transmission region 10a of the display 10 changes along with a location of the camera module.

In some other embodiments, the optical device 30 may alternatively be an ambient light sensor, an optical proximity sensor, or an optical fingerprint sensor. When the optical device 30 is an optical fingerprint sensor, the fingerprint sensor may alternatively be mounted on the second enclosure part 202 of the housing 20, and the light transmission region 10a of the display 10 may be located on the second part 102 of the display 10. A specific type of the optical device 30 and a specific location of the light transmission region 10a are not strictly limited in embodiments of this application. In some other embodiments, the optical device 30 may alternatively be an active light emitting device like a laser or an infrared remote control lamp (for example, an infrared light emitting diode lamp).

In this embodiment of this application, optical effect (for example, a transmittance or a haze) of the light transmission region 10a of the display 10 affects lighting quality of the optical device 30, and further affects function implementation of the optical device 30. For example, when the optical device 30 is a camera module, high lighting quality indicates high imaging quality. When the optical device 30 is a detection module like an ambient light sensor, an optical proximity sensor, or an optical fingerprint sensor, high lighting quality indicates high detection precision. A transmittance (transmittance) is a percentage of luminous flux passing through a transparent or translucent body in incident luminous flux. The haze (haze) is a percentage of intensity of transmitted light that deviates from incident light by more than 2.5 degrees in total transmitted light intensity. A higher indicates a decrease in film luster, transparency, and especially imaging effect. Generally, a higher transmittance indicates a lower haze. Therefore, in this embodiment of this application, the light transmission region 10a of the display 10 is configured as a structure with a high transmittance, so that lighting quality of the optical device 30 is good, and a function of the optical device 30 is implemented conveniently.

In some embodiments, the electronic device 100 may further include a plurality of components (not shown in the figure). The plurality of components are mainly accommodated inside the first enclosure part 201 and the second enclosure part 202, and some components may alternatively be at least partially mounted on the rotating shaft. This is not strictly limited in embodiments of this application. The plurality of components of the electronic device 100 may include but are not limited to a processor, an internal processor, an external storage interface, a universal serial bus (universal serial bus, USB) interface, a charging management module, a power management module, a battery, an antenna, a communication module, a camera module, an audio module, a speaker, a receiver, a microphone, a headset jack, a sensor module, a subscriber identification module (subscriber identification module, SIM) card interface, and one or more rigid circuit boards or flexible circuit boards. The electronic device 100 may have more or fewer components than those described above, may combine two or more components, or may have different component configurations. A quantity, types, locations, and the like of modules of the electronic device 100 are not limited in embodiments of this application.

The following describes an implementation structure of the display 10 of the electronic device 100 in some embodiments by using examples.

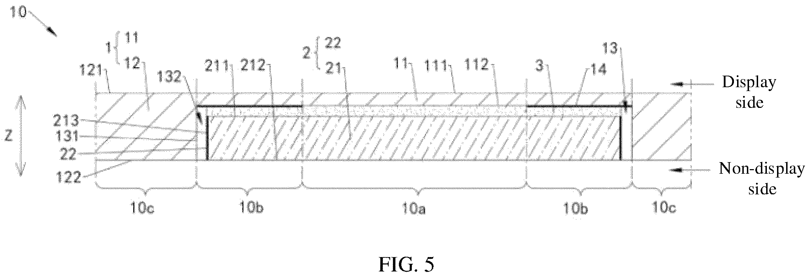

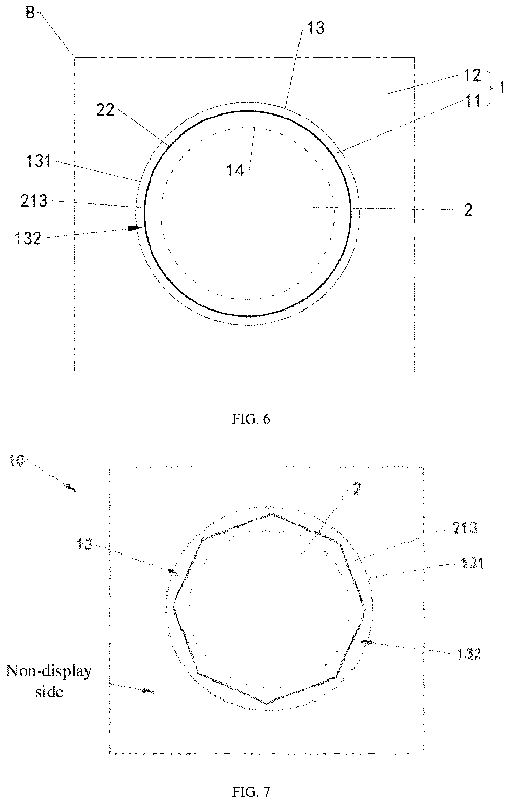

FIG. 4 is a diagram of a structure of the display 10 of the electronic device 100 shown in FIG. 1 according to some embodiments. FIG. 5 is a diagram of a cross-sectional structure of the display 10 shown in FIG. 4 cut along A-A. FIG. 6 is an enlarged diagram of a structure of the display 10 shown in FIG. 4 at a location B. A viewing angle of the display 10 in FIG. 4 is a viewing angle from the non-display side of the display 10 toward the display 10. For ease of description, in the following, the orientation where the display 10 and its component approach the display side of the display 10 is defined as "outside", and the orientation where the display 10 and its component approach the non-display side of the display 10 is defined as "inside". It should be noted that FIG. 4 and the following related accompanying drawings schematically show only some components included in the display 10. Actual shapes, actual sizes, actual locations, and actual structures of these components are not limited to those in FIG. 4 and the following accompanying drawings.

In some embodiments, as shown in FIG. 4 and FIG. 5, the display 10 includes a display screen 1 and a reinforcing plate 2. The display screen 1 may be a bendable flexible display screen. For example, the display screen 1 may be an organic light-emitting diode (organic light-emitting diode, OLED) display screen, an active-matrix organic light-emitting diode (active-matrix organic light-emitting diode, AMOLED) display screen, a mini organic light-emitting diode (mini organic light-emitting diode) display screen, a micro light-emitting diode (micro light-emitting diode) display screen, a micro organic light-emitting diode (micro organic light-emitting diode) display screen, or a quantum dot light emitting diode (quantum dot light emitting diode, QLED) display screen.

In some embodiments, as shown in FIG. 5 and FIG. 6, the display screen 1 may include a first screen part 11 and a second screen part 12, the second screen part 12 surrounds the first screen part 11, and the second screen part 12 is connected to the first screen part 11. The first screen part 11 and the second screen part 12 may be an integrally formed mechanical part. The first screen part 11 includes a first outer surface 111 and a first inner surface 112 that are disposed back to back, and the second screen part 12 includes a second outer surface 121 and a second inner surface 122 that are disposed back to back. The first outer surface 111 and the second outer surface 121 face the display side of the display 10, and the first inner surface 112 and the second inner surface 122 face the non-display side of the display. The first outer surface 111 is flush with the second outer surface 121, so that a display surface of the display 10 is flat, and appearance consistency is good. The first inner surface 112 is recessed relative to the second inner surface 122 to form a groove 13. In this case, a thickness of the first screen part 11 is less than a thickness of the second screen part 12, and the groove 13 is formed on an inner side of the first screen part 11. An opening of the groove 13 faces the non-display side of the display 10.

The second screen part 12 of the display screen 1 is configured to display an image. The second screen part 12 of the display screen 1 has a conventional display structure, and the conventional display structure corresponds to a fully stacking structure of the display screen 1. Compared with the second screen part 12, the first screen part 11 of the display screen 1 may obtain a smaller quantity of stack layers and a smaller thickness by reducing some stack layers and reserving some stack layers. At least a partial region of the first screen part 11 allows external light to pass through, and the region that is of the first screen part 11 and that allows external light to pass through is a light transmission region of the first screen part 11. In this embodiment of this application, "at least a partial region" includes two cases: a partial region and an entire region. When the display 10 is not assembled in the electronic device 100, for the display 10, external light is the light outside the display 10. In comparison with a display having a light transmission region with a fully stacking structure in a conventional under-display camera structure, the first screen part 11 in this embodiment has a smaller thickness and a smaller quantity of stack layers. Therefore, the light transmission region of the first screen part 11 has higher transmittance.

For example, the reinforcing plate 2 is located on a side that is of the first inner surface 112 and that is away from the first outer surface 111, and the reinforcing plate 2 and the first screen part 11 are stacked, and are fastened to the display screen 1. In this case, the reinforcing plate 2 is fastened to the inner side of the first screen part 11 through stacking. The reinforcing plate 2 is at least partially located in the groove 13. For example, in the embodiment shown in FIG. 5, the reinforcing plate 2 may be completely located in the groove 13. In some other embodiments, the reinforcing plate 2 may alternatively be partially located in the groove 13.

At least a partial region of the reinforcing plate 2 allows external light to pass through, and the region that is of the reinforcing plate 2 and that allows external light to pass through is a light transmission region of the reinforcing plate 2. External light can pass through the first screen part 11 and the reinforcing plate 2, and enter non-display side space of the display 10. For example, the light transmission region of the reinforcing plate 2 and the light transmission region of the first screen part 11 are disposed directly opposite to each other. In a thickness direction Z of the display 10, there is an overlapping region between the light transmission region of the reinforcing plate 2 and the light transmission region of the first screen part 11. External light sequentially passes through the light transmission region of the first screen part 11 and the light transmission region of the reinforcing plate 2, and enters the non-display side space of the display 10.

In this embodiment of this application, the light transmission region 10a of the display 10 is disposed corresponding to the light transmission region of the first screen part 11 and the light transmission region of the reinforcing plate 2, to obtain a high transmittance. Because the reinforcing plate 2 and the first screen part 11 are stacked, the reinforcing plate 2 can increase structural strength of the first screen part 11, to increase structural strength of the display screen 1 in the groove 13. So when the display 10 is externally pressed, squeezed, or impacted, there is a low risk of deformation or damage, and the display 10 has high reliability. In addition, because the reinforcing plate 2 is at least partially located in the groove 13, a gap between the reinforcing plate 2 and the first screen part 11 is small. When the first screen part 11 is squeezed or pressed, deformation space in the thickness direction Z of the display 10 is small, so that reinforcing effect of the reinforcing plate 2 on the first screen part 11 is better.

In the thickness direction Z of the display 10, the light transmission region of the first screen part 11 completely covers the light transmission region 10a of the display 10, and the light transmission region of the reinforcing plate 2 completely covers the light transmission region 10a of the display 10, so that the light transmission region 10a of the display 10 has a high overall transmittance, and optical path environments are consistent or similar. In this way, lighting quality of the optical device 30 located below the light transmission region 10a of the display 10 is better.

In some embodiments, there may be one or more stack layers of the first screen part 11 of the display screen 1, and most or all of the stack layers of the first screen part 11 may be stack layers with high transmittance. In this case, the transmittance of the first screen part 11 is high, so that a transmittance of the light transmission region 10a of the display 10 is high. This helps improve lighting quality of the optical device 30. For example, transmittances of all or most of the stack layers of the first screen part 11 may be greater than or equal to 20%, for example, 45%, 68%, 80%, 85%, 91%, 93% or 98%. A minimum value of a transmittance of the stack layer of the first screen part 11 changes based on a lighting requirement of the optical device 30.

In some embodiments, the display screen 1 may include a first stack layer (not shown in the figure) and a second stack layer (not shown in the figure). The first stack layer is located on the first screen part 11 and the second screen part 12, and the second stack layer is located on the second screen part 12. A transmittance of the first stack layer is higher than a transmittance of the second stack layer. In other words, in comparison with the second screen part 12, the first screen part 11 reserves the first stack layer with a high transmittance and reduces the second stack layer with a low transmittance. For example, the transmittance of the first stack layer is higher than 20%, and the transmittance of the second stack layer is lower than 20%.

In this embodiment, a stack layer with a low transmittance is reduced and a stack layer with a high transmittance is reserved for the first screen part 11, to help improve an overall transmittance. The first stack layer is one of stack layers reserved for the first screen part 11, and the second stack layer is one of stack layers reduced by the first screen part 11 in comparison with the second screen part 12. In this embodiment of this application, all stack layers reduced for the first screen part 11 relative to the second screen part 12 are not limited to stack layers with low transmittances, or may include some stack layers with high transmittances, and all the stack layers of the first screen part 11 are not limited to stack layers with high transmittances, it is also allowed that the first screen part 11 includes a stack layer (for example, a light shielding layer used for light shielding in the following) with a low transmittance for implementing another function.

The first screen part 11 may be formed for the display screen 1 by removing some stack layers in a local region through mechanical machining. Alternatively, the first screen part 11 may be formed for the display screen 1 by reducing a forming quantity of stack layers in a local region in a manufacturing process. This is not strictly limited in embodiments of this application.

In some embodiments, a transmittance of the reinforcing plate 2 is higher than the transmittance of the second stack layer. For example, a transmittance of the region that is of the reinforcing plate 2 and that allows external light to pass through is higher than the transmittance of the second stack layer. In this embodiment, the transmittance of the reinforcing plate 2 is higher than the transmittance of the stack layer reduced for the first screen part 11, so that an overall transmittance of a stacking structure of the first screen part 11 and the reinforcing plate 2 is higher than a transmittance of the second screen part 12. In this way, the light transmission region 10a located on the stacking structure has a high transmittance, to help improve lighting quality of the optical device 30.

In some embodiments, as shown in FIG. 5, the reinforcing plate 2 is of a flat plate structure. The reinforcing plate 2 includes a first plate surface 211, a second plate surface 212, and a peripheral side surface 213. The first plate surface 211 and the second plate surface 212 are disposed back to back and are parallel to each other, and the peripheral side surface 213 is connected to the first plate surface 211 and the second plate surface 212 in an encircling manner. The first plate surface 211 of the reinforcing plate 2 is disposed facing the first screen part 11, and the second plate surface 212 is disposed away from the first screen part 11. In this embodiment, the reinforcing plate 2 has a simple structure, is easy to process, and has low costs.

For example, the reinforcing plate 2 is parallel to the first screen part 11. Specifically, both the first plate surface 211 and the second plate surface 212 of the reinforcing plate 2 are parallel to the first outer surface 111 of the first screen part 11. In this case, distortion of external light in a process of passing through the first screen part 11 and the reinforcing plate 2 is slight, so that the optical device 30 can collect high-quality external light through the light transmission region 10a of the display 10. For example, when the optical device 30 is a camera module, image shooting quality of the camera module is good.

For example, a main structure of the reinforcing plate 2 is a plate body 21. The plate body 21 of the reinforcing plate 2 may be made of a material with a high transmittance and high structural strength. The transmittance of the plate body 21 of the reinforcing plate 2 may be adjusted based on the lighting requirement of the optical device 30. For example, the transmittance of the plate body 21 of the reinforcing plate 2 is greater than or equal to 20%, for example, 40%, 65%, 83%, 85%, 91%, 93% or 96%. In some examples, the transmittance of the plate body 21 of the reinforcing plate 2 may be greater than or equal to 80%, to help external light pass through the light transmission region 10a of the display 10, so as to increase an amount of light received by the camera module. In this way, imaging quality of the camera module is high, and a risk of occurrence of stray light and ghosting is reduced.

For example, the plate body 21 of the reinforcing plate 2 may be made of a polymer material or optical glass. For example, a material of the plate body 21 of the reinforcing plate 2 may be transparent plastic, for example, a polyethylene terephthalate (polyethylene terephthalate, PET) material, a polycarbonate (polycarbonate, PC) material, a colorless polyimide (colorless polyimide, CPI) material, a cyclo olefin polymer (cyclo olefin polymer, COP) material, or a triacetyl cellulose (triacetyl cellulose, TAC) material, or a material of the plate body 21 of the reinforcing plate 2 may be ultra thin glass (ultra thin glass, UTG).

In some embodiments, as shown in FIG. 5, the display 10 further includes a bonding member 3. The bonding member 3 is located between the reinforcing plate 2 and the first inner surface 112 and is fastened to the reinforcing plate 2 and the first inner surface 112. In this case, the bonding member 3 is fastened to the first plate surface 211 of the reinforcing plate 2. The reinforcing plate 2 is fastened to the first inner surface 112 of the first screen part 11 through stacking. The reinforcing plate 2 can directly reinforce the first screen part 11 with a good reinforcing effect. In addition, the reinforcing plate 2 and the first screen part 11 are compactly arranged, to help control a thickness of the light transmission region 10a of the display 10, so that when a location of the optical device 30 is a bottleneck of an overall thickness of the electronic device 100, the overall thickness of the electronic device 100 can be effectively controlled. This helps implement thinning of the electronic device 100.

The bonding member 3 allows external light to pass through. The bonding member 3 may be made of a material with a high transmittance. For example, a transmittance of the bonding member 3 may be greater than or equal to 20%, for example, 40%, 65%, 83%, 85%, 91%, 93%, or 96%. In some examples, the transmittance of the bonding member 3 is greater than or equal to 80%. For example, a bonding adhesive may be an optically clear adhesive (optically clear adhesive, OCA) or a pressure-sensitive adhesive.

For example, as shown in FIG. 5, in the thickness direction Z of the display 10, a sum of a thickness of the reinforcing plate 2 and a thickness of the bonding member 3 is equal to a depth of the groove 13. In this case, the second plate surface 212 of the reinforcing plate 2 is flush with the second inner surface 122 of the second screen part 12, and disposing of the reinforcing plate 2 does not increase the thickness of the display 10. This facilitates thinning of the electronic device 100, and flattens an inner surface of the display 10 to help reduce assembly difficulty of the display 10, and simplify an assembly structure of the display 10.

In some embodiments, as shown in FIG. 5 and FIG. 6, a surface that is of the second screen part 12 and that faces the groove 13 is a side wall 131 of the groove 13, and a gap 132 is formed between the peripheral side surface 213 of the reinforcing plate 2 and the side wall 131 of the groove 13. In this embodiment, the gap 132 between the peripheral side surface 213 of the reinforcing plate 2 and the side wall 131 of the groove 13 is an assembly gap. Disposing the assembly gap can reduce a risk of damage caused by the reinforcing plate 2 to the display screen 1, to protect the display screen 1.

FIG. 7 is a diagram of a partial structure of the display 10 shown in FIG. 1 according to some other embodiments. A viewing angle of the display 10 in FIG. 7 is a viewing angle from the non-display side of the display 10 toward the display 10. The display 10 in the embodiment of FIG. 7 may include most technical features of the display 10 in the foregoing embodiment. The following mainly describes a difference between the two, and a same part between the two is not described again.

In this embodiment of this application, a shape of the reinforcing plate 2 may have a plurality of implementation structures, and the shape of the reinforcing plate 2 may adapt to a shape of the groove 13 as much as possible, to fully support the first screen part 11. For example, as shown in FIG. 6, the groove 13 is a circular groove, and the reinforcing plate 2 is a circular plate. Alternatively, as shown in FIG. 7, the groove 13 is a circular groove, and the reinforcing plate 2 is a polygonal plate, for example, an octagonal plate. In some other embodiments, a quantity of sides of the reinforcing plate 2 may alternatively be six sides, four sides, 12 sides, or the like. In some other embodiments, the reinforcing plate 2 may alternatively be of a flat plate structure of another shape. A shape of the reinforcing plate 2 is not strictly limited in embodiments of this application. In some other embodiments, the groove 13 may alternatively have another shape, for example, a polygon. A shape of the groove 13 is not strictly limited in embodiments of this application.

In some embodiments, in a plane direction of the display 10, an opening area of the groove 13 is a first area, a part that is of the reinforcing plate 2 and that is located in the groove 13 has a second area, and a ratio of the second area to the first area is greater than or equal to 80%. For example, the ratio of the second area to the first area may be 82%, 84%, 85.6%, 88%, 90%, 92%, 95%, or the like. The plane direction of the display 10 is perpendicular to a thickness direction Z of the display 10.

In this embodiment, because the ratio of the area of the part that is of the reinforcing plate 2 and that is located in the groove 13 to the opening area of the groove 13 is greater than or equal to 80%, the area of the part that is of the reinforcing plate 2 and that is located in the groove 13 is large, so that the first screen part 11 can be better supported, and reliability of the display 10 is improved. In addition, because an area of the reinforcing plate 2 is large, it is helpful to ensure that external light can pass through the reinforcing plate 2 when entering the non-display side space of the display 10 through the light transmission region 10a of the display 10, and an optical path environment is consistent or similar, so that an image collected by the optical device 30 has a lower risk of distortion, and lighting quality of the optical device 30 is improved.

It may be understood that, the ratio of the second area to the first area is expected to be as large as possible when it is ensured that there is a sufficient assembly gap between the peripheral side surface 213 of the reinforcing plate 2 and the groove wall of the groove 13, to provide a better supporting environment and an optical path environment.

In some embodiments, in a circumferential direction of the reinforcing plate 2, a width of the gap 132 between the peripheral side surface 213 of the reinforcing plate 2 and the side wall 131 of the groove 13 may be unchanged or may be changed. For example, as shown in FIG. 6, the side wall 131 of the groove 13 is a cylindrical surface, and the peripheral side surface 213 of the reinforcing plate 2 is a cylindrical surface. Center lines of the two coincide, and the width of the gap 132 remains unchanged in the circumference direction of the reinforcing plate 2. Alternatively, the side wall 131 of the groove 13 may be a cylindrical surface, and the peripheral side surface 213 of the reinforcing plate 2 is also a cylindrical surface. Center lines of the two are staggered, and the width of the gap 132 changes in the circumference direction of the reinforcing plate 2. Alternatively, as shown in FIG. 7, the side wall 131 of the groove 13 may be a cylindrical surface, and the peripheral side surface 213 of the reinforcing plate 2 is a polygonal cylindrical surface. Center lines of the two overlap, and the width of the gap 132 changes in the circumference direction of the reinforcing plate 2. A specific value and a design rule of the width of the gap 132 between the peripheral side surface 213 of the reinforcing plate 2 and the side wall 131 of the groove 13 are not strictly limited in embodiments of this application.

In some embodiments, as shown in FIG. 5 and FIG. 6, the reinforcing plate 2 further includes a light blocking layer 22, and the light blocking layer 22 covers the peripheral side surface 213 of the plate body 21. The light blocking layer 22 may be made of a light absorbing material or a light blocking material, to block an optical path. For example, the light blocking layer 22 may be an ink layer, and the ink layer may be formed by directly coating ink on the peripheral side surface 213 of the plate body 21. Alternatively, the light blocking layer 22 may be a black film, and the black film may be fastened to the peripheral side surface 213 of the plate body 21 through bonding or the like.

In this embodiment, the light blocking layer 22 of the reinforcing plate 2 is disposed facing the side wall 131 of the groove 13. The light blocking layer 22 may absorb stray light or block propagation of stray light, to reduce stray light entering a lighting path of the optical device 30, and reduce a risk of light crosstalk, so as to improve lighting quality of the optical device 30. The stray light may be, but is not limited to, light emitted by the display screen 1, or light emitted by a component like a flash in the electronic device 100.

In some embodiments, as shown in FIG. 5 and FIG. 6, the display screen 1 may include a light shielding layer 14, and the light shielding layer 14 is annular. The light shielding layer 14 is at least partially located on the first screen part 11. In other words, the light shielding layer 14 is at least a partial structure of the first screen part 11. In the thickness direction Z of the display 10, the light shielding layer 14 covers the gap 132 and a periphery of the reinforcing plate 2, and exposes a middle part of the reinforcing plate 2. The light shielding layer 14 may be made of a light absorbing material or a light blocking material. For example, the light shielding layer 14 may be an ink layer. The periphery of the reinforcing plate 2 and the middle part of the reinforcing plate 2 are two regions of the reinforcing plate 2, and the periphery of the reinforcing plate 2 is disposed around the middle part of the reinforcing plate 2. There is a relative location relationship between the periphery and the middle part. However, how to locate a boundary between the periphery and the middle part is not strictly limited in embodiments of this application. For example, in a radial direction of the reinforcing plate 2, a width of the periphery of the reinforcing plate 2 may be greater than, equal to, or less than a width of the middle part of the reinforcing plate 2. The radial direction of the reinforcing plate 2 is parallel to a plate surface of the reinforcing plate 2, and passes through a center line of the reinforcing plate 2. The center line of the reinforcing plate 2 is perpendicular to the plate surface of the reinforcing plate 2.

In this embodiment, the light shielding layer 14 shields the gap 132 between the reinforcing plate 2 and the side wall 131 of the groove 13, and the periphery of the reinforcing plate 2, so that appearance effect of the display 10 can be improved. In addition, the light shielding layer 14 can further absorb stray light, to reduce stray light entering a lighting path of the optical device 30, so as to improve lighting quality of the optical device 30. The stray light may be, but is not limited to, light emitted by the display screen 1, or light emitted by a component like a flash in the electronic device 100.

For example, the light shielding layer 14 may be annular. The light shielding layer 14 includes an inner ring surface and an outer ring surface that are disposed opposite to each other, and both the inner ring surface and the outer ring surface are circular. In some other embodiments, the light shielding layer 14 may alternatively be of another ring structure, for example, an elliptic ring or a square ring. In some other embodiments, the light shielding layer 14 may alternatively be in a special ring shape. For example, a shape of the inner ring surface of the light shielding ring may be different from a shape of the outer ring surface. For example, the shape of the inner ring surface is a circle, and the shape of the outer ring surface is a square. Alternatively, a shape of the inner ring surface of the light shielding ring is the same as a shape of the outer ring surface, but centers of the inner ring surface and the outer ring surface are staggered. A specific shape of the light shielding layer 14 is not strictly limited in embodiments of this application.

For example, a spacing between the inner ring surface and the outer ring surface of the light shielding layer 14 may be from 0.05 mm to 0.3 mm, for example, 0.1 mm, 0.12 mm, 0.15 mm, or 0.2 mm.

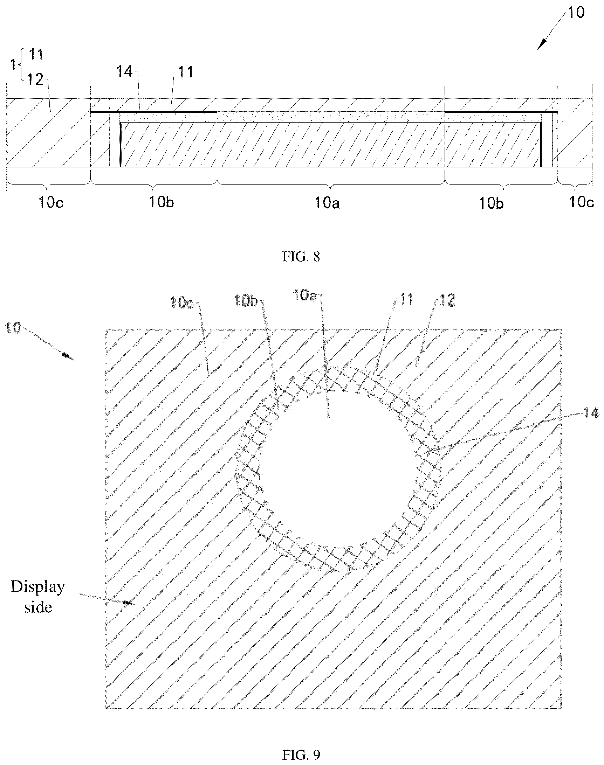

FIG. 8 is a partial diagram of an internal structure of the display 10 of the electronic device 100 shown in FIG. 1 according to some other embodiments. The display 10 in the embodiment of FIG. 8 may include most technical features of the display 10 in the foregoing embodiment. The following mainly describes a difference between the two, and a same part between the two is not described again.

In some embodiments, as shown in FIG. 5, the light shielding layer 14 may be completely located on the first screen part 11. In this case, the first screen part 11 includes the light shielding layer 14. In some other embodiments, as shown in FIG. 8, the light shielding layer 14 may be partially located on the first screen part 11 and partially located on the second screen part 12. In other words, the light shielding layer 14 may extend from the first screen part 11 to the second screen part 12. A shape of a part that is of the light shielding layer 14 and that is located on the second screen part 12 may be regular or irregular. This is not strictly limited in embodiments of this application. The light shielding layer 14 may be formed in a preparation process of the display screen 1.

In this embodiment of this application, a shape and a location of the light shielding layer 14 affect display effect of the display 10.

FIG. 9 is a diagram of a partial structure of the display 10 shown in FIG. 4 from another perspective. A viewing angle of the display 10 in FIG. 9 is a viewing angle from the display side of the display toward the display 10.

In some embodiments, as shown in FIG. 5 and FIG. 9, the display 10 further includes a light shielding region 10b and a display area 10c. The light shielding region 10b is disposed around the light transmission region 10a, and the display area 10c is disposed around the light shielding region 10b. In FIG. 9, for ease of illustration, the display area 10c is shown by using tilted filling lines, the light shielding region 10b is shown by using grid filling lines, and the light transmission region 10a has no filling line. The display area 10c of the display 10 corresponds to the second screen part 12 of the display screen 1, and is used to display an image. The light shielding region 10b located between the display area 10c and the light transmission region 10a can block external light. The light shielding region 10b is disposed corresponding to the light shielding layer 14 of the display screen 1. In some examples, an edge part that is of the second screen part 12 of the display screen 1 and that is close to the groove 13 may not be used to display an image, but is used to block external light. In this case, the light shielding region 10b is further disposed corresponding to this part of structure. In some embodiments, the light shielding region 10b may also be used to shield light inside the electronic device 100.

In this embodiment, because the light shielding layer 14 is annular, the light transmission region 10a is circular, and the light shielding region 10b is annular. Because the light shielding layer 14 is completely located on the first screen part 11, the light shielding region 10b is correspondingly located on the first screen part 11.

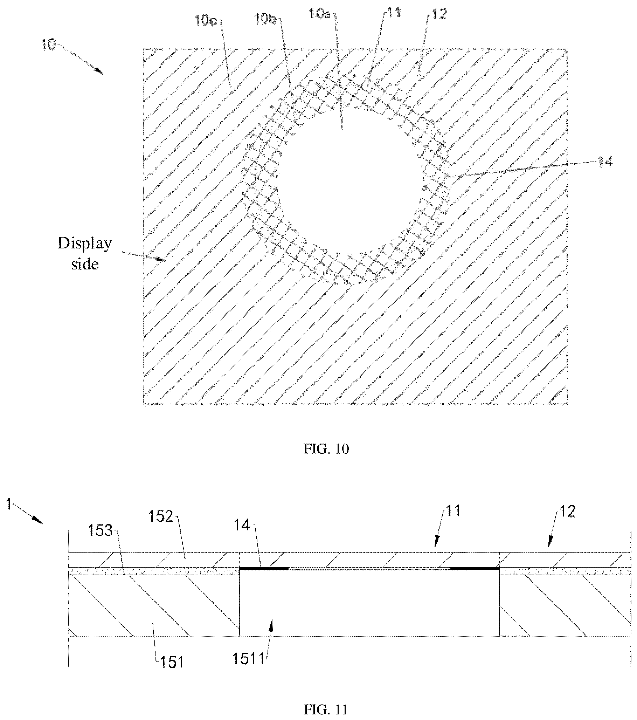

FIG. 10 is a diagram of a partial structure of the display 10 shown in FIG. 8 from another perspective. A viewing angle of the display 10 in FIG. 10 is a viewing angle from the display side of the display toward the display 10.

In some other embodiments, as shown in FIG. 8 and FIG. 10, the light shielding layer 14 is partially located on the first screen part 11 and partially located on the second screen part 12, a location of the light shielding region 10b changes with the light shielding layer 14, and the light shielding region 10b is partially located on the first screen part 11 and partially located on the second screen part 12. For example, both the inner ring surface and the outer ring surface of the light shielding layer 14 may be circular, and centers of the two are staggered. In this case, the light shielding layer 14 is in an abnormal-shaped ring, the light shielding region 10b is correspondingly an abnormal-shaped ring region, the light transmission region 10a is circular, and a non-display region (namely, a region formed by both the light transmission region 10a and the light shielding region 10b) surrounded by the display area 10c is circular.

In this embodiment of this application, there may be a plurality of implementation structures of the first screen part 11 of the display screen 1.

In some examples, in comparison with the second screen part 12, the first screen part 11 reserves a cover layer (cover layer) of the display 10, namely, a stack layer that is of the display 10 and that is closest to the user. The first screen part 11 further includes the light shielding layer 14, and the light shielding layer 14 is stacked on an inner surface of the cover layer. In comparison with the second screen part 12, the first screen part 11 reserves another stack layer.

FIG. 11 is a diagram of a structure of the display screen 1 shown in FIG. 5 in some examples.

In some examples, as shown in FIG. 11, the display screen 1 includes a display panel 151, a protection cover 152, the light shielding layer 14, and a bonding layer 153. The display panel 151 is provided with a light through hole 1511. The protection cover 152 is stacked on a light outlet side of the display panel 151, the protection cover 152 covers the light through hole 1511, and the light shielding layer 14 is fastened to a surface that is of the protection cover 152 and that faces the light through hole 1511. The bonding layer 153 is located between the display panel 151 and the protection cover 152, and is bonded to the display panel 151 and the protection cover 152.

In this example, the light shielding layer 14 and a part that is of the protection cover 152 and that corresponds to the light through hole 1511 form the first screen part 11, and the other part of the protection cover 152, the bonding layer 153, and the display panel 151 form the second screen part 12. The protection cover 152 may include one or more stack layers, and the display panel 151 includes a plurality of stack layers. One stack layer of the protection cover 152 corresponds to the foregoing first stack layer, and one stack layer of the display panel 151 corresponds to the foregoing second stack layer. The bonding layer 153 may be made of an optically clear adhesive.

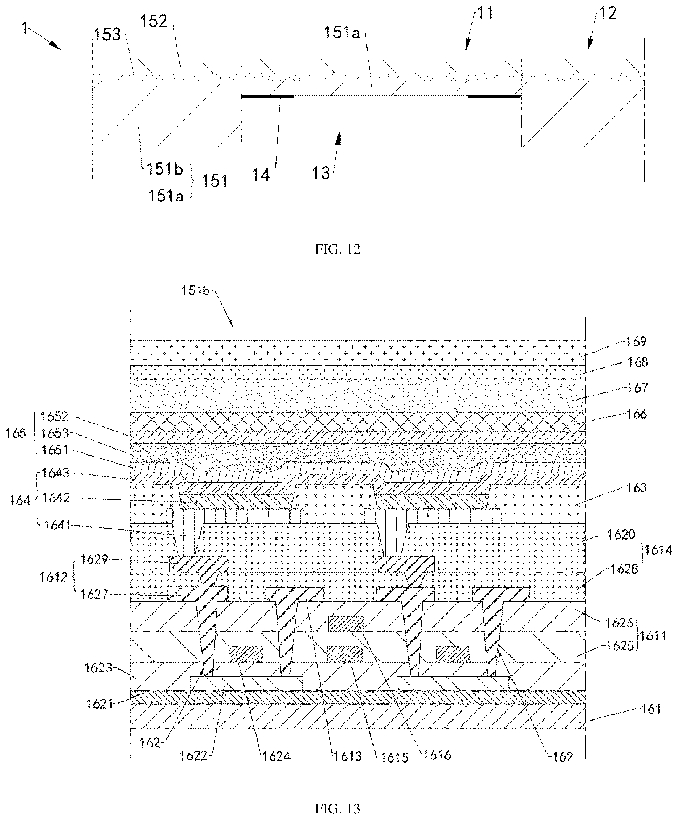

FIG. 12 is a diagram of a structure of the display screen 1 shown in FIG. 5 in some other examples.

In some examples, as shown in FIG. 12, the display screen 1 includes the display panel 151, the protection cover 152, the light shielding layer 14, and the bonding layer 153. The protection cover 152 is stacked on a light emission side of the display panel 151, and the bonding layer 153 is located between the display panel 151 and the protection cover 152, and is bonded to the display panel 151 and the protection cover 152. The display panel 151 includes a first part 151a with a small thickness and a second part 151b with a large thickness. The groove 13 is formed on a side that is of the first part 151a and that is away from the protection cover 152, and the light shielding layer 14 is fastened to a surface that is of the first part 151a and that is away from the protection cover 152.

In this example, a part that is of the protection cover 152 and that corresponds to the groove 13, a part that is of the bonding layer 153 and that corresponds to the groove 13, the first part 151a of the display panel 151, and the light shielding layer 14 form the first screen part 11, and the other part of the protection cover 152, the other part of the bonding layer 153, and the second part 151b of the display panel 151 form the second screen part 12. The protection cover 152 may include one or more stack layers, and the display panel 151 includes a plurality of stack layers. One stack layer of the protection cover 152 or the first part 151a of the display panel 151 corresponds to the foregoing first stack layer, and one stack layer of the second part 151b of the display panel 151 corresponds to the foregoing second stack layer. The bonding layer 153 may be made of an optically clear adhesive.

FIG. 13 is a diagram of an internal structure of the second part 151b of the display panel 151 of the display screen 1 shown in FIG. 12.

In some embodiments, as shown in FIG. 13, the display panel 151 may be an organic light emitting diode panel. The second part 151b of the display panel 151 may include a basal plate (basal plate, BP) 161, a thin film transistor (thin film transistor, TFT) 162, a pixel define layer (pixel define layer, PDL) 163, a pixel unit layer 164, an encapsulation layer 165, a touch panel (touch panel, TP) 166, an overcoating (overcoating, OC) 167, a connection layer 168, and a polarizer (polarizer, POL) 169. In this embodiment, the polarizer 169 is a layer that is of the display panel 151 and that is close to the user. FIG. 4 merely schematically shows two thin film transistors 162. A quantity of thin film transistors 162 in the second part 151b of the display panel 151 is not specifically limited.

For example, the basal plate 161 is configured to provide a bearing substrate for each layer (for example, the thin film transistor 162) above the basal plate 161. A material of the basal plate 161 may be polyimide (polyimide, PI), or may be polyethylene terephthalate (polyethylene terephthalate, PET), paper, metal, ultra-thin glass, or the like.

As shown in FIG. 13, the thin film transistor 162 includes a buffer (buffer) layer 1621, an active layer 1622, a gate insulator (gate insulator, GI) layer 1623, an interlayer dielectric (inner layer dielectric, ILD) layer 1611, a gate (gate) 1624, a source (source, S) 1612, a drain (drain, D) 1613, a planarization (planarization, PLN) layer 1614, a first wire 1615, and a second wire 1616. For example, the interlayer dielectric layer 1611 includes a first interlayer dielectric layer 1625 and a second interlayer dielectric layer 1626. The source 1612 includes a first source 1627 and a second source 1629. The planarization layer 1614 includes a first planarization layer 1628 and a second planarization layer 1620.

For example, the buffer layer 1621 is disposed on the basal plate 161. The active layer 1622 is disposed on a surface that is of the buffer layer 1621 and that is away from the basal plate 161. The gate insulator layer 1623 is disposed on the surface that is of the buffer layer 1621 and that is away from the basal plate 161, and covers the active layer 1622. Both the gate 1624 and the first wire 1615 are disposed on a surface that is of the gate insulator layer 1623 and that is away from the buffer layer 1621, and the gate 1624 and the first wire 1615 are spaced from each other. The first interlayer dielectric layer 1625 is disposed on the surface that is of the gate insulator layer 1623 and that is away from the buffer layer 1621, and covers the gate 1624 and the first wire 1615. The second wire 1616 is disposed on a surface that is of the first interlayer dielectric layer 1625 and that is away from the gate insulator layer 1623. The second interlayer dielectric layer 1626 is disposed on the surface that is of the first interlayer dielectric layer 1625 and that is away from the gate insulator layer 1623, and covers the second wire 1616.

For example, a part of the first source 1627 and a part of the first drain 1613 are disposed on a surface that is of the second interlayer dielectric layer 1626 and that is away from the first interlayer dielectric layer 1625, and the other part of the first source 1627 and the other part of the first drain 1613 pass through the second interlayer dielectric layer 1626, the first interlayer dielectric layer 1625, and the gate insulator layer 1623 and are connected to the active layer 1622. The first planarization layer 1628 is disposed on the surface that is of the second interlayer dielectric layer 1626 and that is away from the first interlayer dielectric layer 1625, and covers a part of the first source 1627 and a part of the first drain 1613. A part of the second source 1629 is disposed on a surface that is of the first planarization layer 1628 and that is away from the second interlayer dielectric layer 1626, and the other part of the second source 1629 passes through the first planarization layer 1628 and is connected to the first source 1627. The second planarization layer 1620 is disposed on the first planarization layer 1628, and covers a part of the second source 1629.

The foregoing is an implementation of the thin film transistor 162 provided in this application. In another implementation, the thin film transistor 162 may alternatively be provided with only the first source 1627, the first drain 1613, and the first planarization layer 1628. A specific layer structure of the thin film transistor 162 is not limited in embodiments of this application. In addition, locations of the first source 1627 and the first drain 1613 may alternatively be exchanged.

As shown in FIG. 13, the pixel define layer 163 may be disposed on a surface that is of the second planarization layer 1620 of the thin film transistor 162 and that is away from the first planarization layer 1628. The pixel unit layer 164 may be configured to implement a display function, and the pixel unit layer 164 is also referred to as a light emission device layer. The pixel unit layer 164 may include an anode (anode) 1641, a light emission layer (emission layer, EL) 1642, and a cathode (cathode) 1643 that are sequentially stacked. Herein, a part of the anode 1641 may be disposed on a surface that is of the second planarization layer 1620 and that is away from the first planarization layer 1628, and the other part of the anode 1641 may pass through the second planarization layer 1620 and be connected to the second source 1629. The light emission layer 1642 may be disposed on a surface that is of the anode 1641 and that is away from the second planarization layer 1620. The cathode 1643 may be disposed on a surface that is of the light emission layer 1642 and that is away from the anode 1641.

It may be understood that the cathode 1643 may be prepared in a whole-plane vapor deposition mode. Therefore, the cathode 1643 is a whole-layer continuous structure in the second part 151b. A material of the cathode 1643 may be a magnesium silver alloy or another silver-containing alloy.

For example, a material of the light emission layer 1642 may be an organic material, including an organic small molecular light emission material, a complex light emission material, a polymer, and the like.

As shown in FIG. 13, the encapsulation layer 165 includes a first encapsulation layer 1651, a second encapsulation layer 1652, and a flexible interlayer 1653. The first encapsulation layer 1651 is located on a surface that is of the cathode 1643 and that is away from the light emission layer 1642. The flexible interlayer 1653 is located between the first encapsulation layer 1651 and the second encapsulation layer 1652.

It may be understood that, because the material of the light emission layer 1642 is an organic material, the organic material is easily oxidized when being in contact with water vapor and oxygen, and consequently the light emission layer 1642 fails. In this case, the encapsulation layer 165 may encapsulate the pixel unit layer 164, that is, protect the pixel unit layer 164, to avoid an impact of components such as water vapor and oxygen in the air on a life of the light emission layer 1642.

It may be understood that the flexible interlayer 1653 may be configured to play a water and oxygen buffering role for structures such as the thin film transistor 162 and the pixel unit layer 164 below the encapsulation layer 165, to reduce an encapsulation failure caused by a foreign matter. The first encapsulation layer 1651 and the second encapsulation layer 165 may further seal the flexible interlayer 1653.

For example, the first encapsulation layer 1651 and the second encapsulation layer 1652 may be SiO₂ layers or Si₃N₄ layers manufactured through chemical vapor deposition (chemical vapor deposition, CVD). The flexible interlayer 1653 may be acrylate or a cured polyester polymer organic layer formed by using an ink jet print (ink jet print, IJP) technology.

For example, the touch panel 166 is located on a surface that is of the encapsulation layer 165 and that is away from the basal plate 161. The overcoating 167 is disposed on a surface that is of the touch panel 166 and that is away from the pixel unit layer 164. The connection layer 168 is disposed between the overcoating 167 and the polarizer 169. A material of the connection layer may be a pressure sensitive adhesive (Pressure Sensitive Adhesive, PSA).

In the second part 151b of the display panel 151, one or more of the buffer layer 1621, the gate insulator layer 1623, the interlayer dielectric layer 1611, the planarization layer 1614, the encapsulation layer 165, the touch panel 166, the overcoating 167, the connection layer 168, and the polarizer 169 may be made of materials with high transmittances. One or more stack layers with high transmittances in the second part 151b of the display panel 151 may be laid in the first part 151a of the display panel 151, to form a part of the first screen part 11 of the display screen 1. For example, the first part 151a of the display panel 151 may include the encapsulation layer 165, the touch panel 166, the overcoating 167, the connection layer 168, and the polarizer 169, and other stack layers are reduced. Specific stack layers of the first part 151a of the display panel 151 are not strictly limited in embodiments of this application.

In some other embodiments, the stack layers of the second part 151b of the display panel 151 may also have different implementation structures. For example, the touch panel 166 may not be included, and related stack layers of the first part 151a of the display panel 151 are adaptively changed.

It may be understood that the foregoing several example structures of the display screen 1 are described by using an example in which the light shielding layer 14 is completely located on the first screen part 11. When the light shielding layer 14 is partially located on the first screen part 11 and partially located on the second screen part 12, a related structure may be adaptively adjusted. Details are not described herein.

The following continues to describe an implementation structure of the display 10 according to this embodiment of this application in some other embodiments.

A main difference between the display 10 in the following embodiment and the display 10 in the foregoing embodiment lies in that a partial structure of the reinforcing plate 2 changes, and/or a partial connection structure between the reinforcing plate 2 and the display screen 1 changes. The following mainly describes changed solution content, and same or similar content is not described in detail. For example, unless otherwise described, for a structure of the display screen 1 in the following embodiments, refer to related descriptions in the foregoing embodiments. For a part of the reinforcing plate 2 that does not change and a part that is of the connection structure between the reinforcing plate 2 and the display screen 1 and that does not change in the following embodiments, refer to related descriptions in the foregoing embodiments.

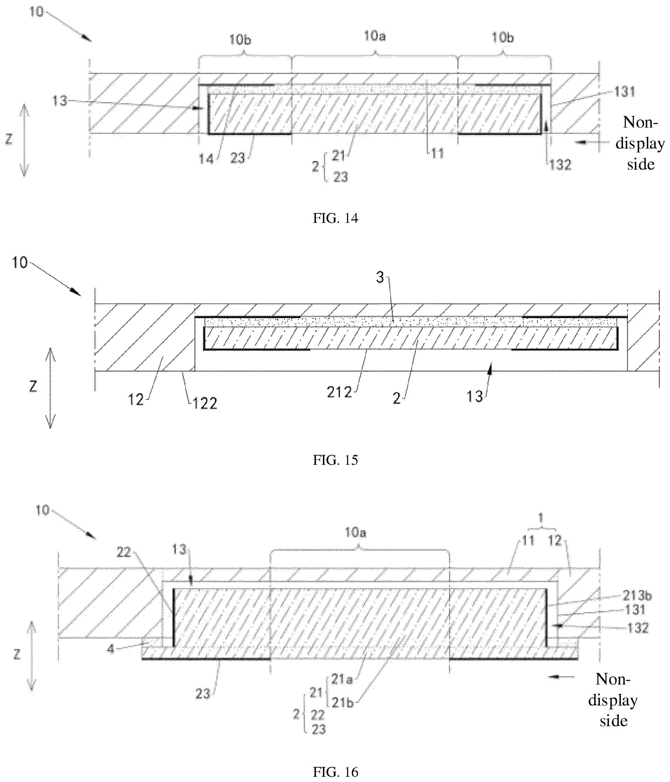

FIG. 14 is a partial diagram of an internal structure of the display 10 of the electronic device 100 shown in FIG. 1 according to some other embodiments. The display 10 in the embodiment of FIG. 14 may include most technical features of the display 10 in the foregoing embodiment. The following mainly describes a difference between the two, and a same part between the two is not described again.

In some embodiments, as shown in FIG. 14, the reinforcing plate 2 may further include a light barrier layer 23, and the light barrier layer 23 is fastened to a plate surface that is of the plate body 21 of the reinforcing plate 2 and that is away from the first screen part 11. The light barrier layer 23 may be annular, an inner diameter of the light barrier layer 23 is less than an inner diameter of the light shielding layer 14, an outer diameter of the light barrier layer 23 is greater than the inner diameter of the light shielding layer 14, and intra-annular space of the light barrier layer 23 is directly opposite to intra-annular space of the light shielding layer 14. The light barrier layer 23 may be made of a light absorbing material or a light blocking material to block an optical path. For example, the light barrier layer 23 may be an ink layer, and the ink layer may be formed by directly coating ink on the plate surface of the plate body 21. Alternatively, the light barrier layer 23 may be a black film, and the black film may be fastened to the plate surface of the plate body 21 through bonding or the like.

In the embodiment in FIG. 14, the light transmission region 10a and the light shielding region 10b of the display 10 change with locations of the light barrier layer 23 and the light shielding layer 14. The light transmission region 10a of the display 10 corresponds to a region in which the intra-annular space of the light barrier layer 23 is located, and the light shielding region 10b corresponds to regions in which the light barrier layer 23 and the light shielding layer 14 are located.

In this embodiment, the plate surface that is of the plate body 21 of the reinforcing plate 2 and that is away from the first screen part 11 is close to the non-display side of the display 10, and is accordingly close to the optical device 30 (not shown in the figure) located on the non-display side of the display 10. Therefore, a distance between the light barrier layer 23 located on the plate surface that is of the plate body 21 and that is away from the first screen part 11 and the optical device 30 is small, and a size of the inner diameter of the light barrier layer 23 may be set to a small size based on a light-receiving field of view characteristic of the optical device 30, so that a size of the outer diameter of the light barrier layer 23 may be small, a size of the outer diameter of the reinforcing plate 2 may be small, and an opening size of the groove 13 of the display screen 1 may be small. This helps reduce an area of a non-display region (namely, a total region including the light transmission region 10a and the light shielding region 10b) of the display 10, and helps increase a screen-to-body ratio of the display 10.

The light shielding layer 14 may shield the gap 132 between the reinforcing plate 2 and the side wall 131 of the groove 13, to shield a light barrier structure difference like an ink difference at an edge of the reinforcing plate 2, so as to improve appearance effect of the display 10.

FIG. 15 is a partial diagram of an internal structure of the display 10 of the electronic device 100 shown in FIG. 1 according to some other embodiments. The display 10 in the embodiment of FIG. 15 may include most technical features of the display 10 in the foregoing embodiment. The following mainly describes a difference between the two, and a same part between the two is not described again.

In some embodiments, as shown in FIG. 15, in the thickness direction Z of the display 10, a sum of the thickness of the reinforcing plate 2 and a thickness of the bonding member 3 is less than a depth of the groove 13. In this case, the second plate surface 212 of the reinforcing plate 2 is recessed relative to the second inner surface 122 of the second screen part 12, and disposing of the reinforcing plate 2 does not increase the thickness of the display 10. This facilitates thinning of the electronic device 100.

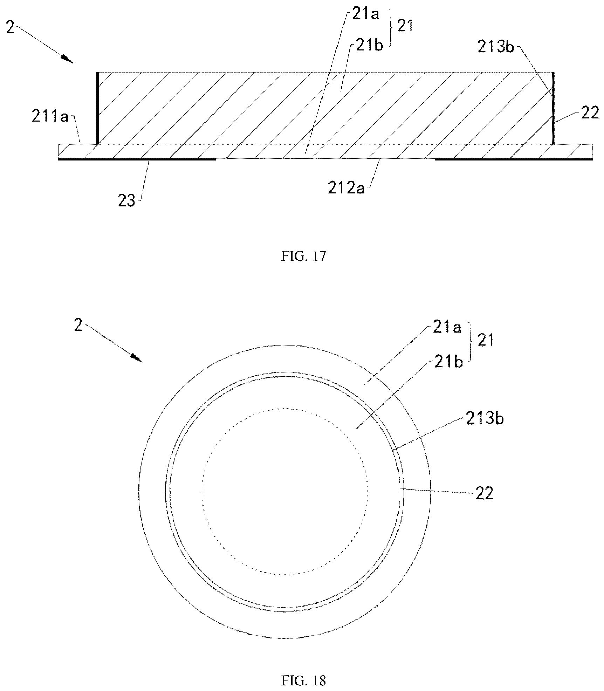

FIG. 16 is a partial diagram of an internal structure of the display 10 of the electronic device 100 shown in FIG. 1 according to some other embodiments. FIG. 17 is a diagram of a structure of the reinforcing plate 2 of the display 10 shown in FIG. 16. FIG. 18 is a diagram of a structure of the reinforcing plate 2 shown in FIG. 17 from another perspective. The display 10 in the embodiment of FIG. 16 may include most technical features of the display 10 in the foregoing embodiment. The following mainly describes a difference between the two, and a same part between the two is not described again.

In some embodiments, as shown in FIG. 16 to FIG. 18, the reinforcing plate 2 includes the plate body 21, and the plate body 21 includes a first plate body 21a and a second plate body 21b. The first plate body 21a is a part of the plate body 21, the second plate body 21b is the other part of the plate body 21, and the first plate body 21a and the second plate body 21b may be stacked. The first plate body 21a and the second plate body 21b may be an integrally formed mechanical part. In some other embodiments, the first plate body 21a and the second plate body 21b may alternatively be connected to each other through a transparent bonding layer.

For example, the first plate body 21a includes a middle part and a periphery. The periphery of the first plate body 21a and the middle part of the first plate body 21a are two parts of the first plate body 21a. The periphery of the first plate body 21a is disposed around the middle part of the first plate body 21a. There is a relative location relationship between the middle part and the periphery. However, how to locate a boundary between the middle part and the periphery is not strictly limited in embodiments of this application. For example, in a radial direction of the first plate body 21a, a width of the periphery of the first plate body 21a may be greater than, equal to, or less than a width of the middle part of the first plate body 21a.

The second plate body 21b is fastened to the middle part of the first plate body 21a. An outer diameter of the first plate body 21a is greater than an outer diameter of the second plate body 21b. The first plate body 21a may be in a circular plate shape, and the second plate body 21b may also be in a circular plate shape. In some other embodiments, the first plate body 21a and the second plate body 21b may alternatively have other shapes. This is not strictly limited in embodiments of this application. For example, a transmittance of the first plate body 21a and a transmittance of the second plate body 21b are both greater than or equal to 20%, for example, 40%, 65%, 83%, 85%, 91%, 93% and 96%.

The reinforcing plate 2 is partially located in the groove 13, and partially located outside the groove 13. For example, the second plate body 21b is at least partially located in the groove 13 of the display screen 1, and the first plate body 21a is located outside the groove 13. The periphery of the first plate body 21a is fastened to the second screen part 12 of the display screen 1. For example, the periphery of the first plate body 21a may be bonded to the second screen part 12 through the adhesive layer 4.

For example, the first plate body 21a may include a first plate surface 211a, and the first plate surface 211a includes a middle part and a periphery. The periphery of the first plate surface 211a and the middle part of the first plate surface 211a are two regions of the first plate surface 211a, and the periphery of the first plate surface 211a is disposed around the middle part of the first plate surface 211 a. There is a relative location relationship between the middle part and the periphery. However, how to locate a boundary between the middle part and the periphery is not strictly limited in embodiments of this application. The second plate body 21b is fastened to the middle part of the first plate surface 211a. The periphery of the first plate surface 211a is fastened to the second screen part 12 of the display screen 1.

In this embodiment, the light transmission region 10a of the display 10 may be disposed corresponding to the first screen part 11, the middle part of the first plate body 21a, and the middle part of the second plate body 21b, and the light transmission region 10a has a high transmittance, so that the optical device 30 (not shown in the figure) on the non-display side of the display 10 implements lighting. Because the first plate body 21a and the second plate body 21b are stacked with the first screen part 11, and the second plate body 21b is at least partially located in the groove 13, the reinforcing plate 2 may increase structural strength of the first screen part 11 and a surrounding location of the first screen part 11, so that structural reliability of the display 10 is improved. In addition, the reinforcing plate 2 is fastened to the second screen part 12, which is thick enough to provide a more reliable fastening structure and a more reliable supporting force, so that the reinforcing plate 2 and the display screen 1 have a more stable and reliable assembly structure.

In some examples, a transmittance of the plate body 21 of the reinforcing plate 2 may be greater than or equal to 80%. This helps external light pass through the light transmission region 10a of the display 10. In this way, when the camera module is used in the optical device 30, setting the transmittance of the plate body 21 helps increase an amount of light received by the camera module, so that imaging quality of the camera module is high, and a risk of occurrence of stray light and ghosting is reduced. Materials of the first plate body 21a and the second plate body 21b may be polymer materials or optical glass. For details, refer to the foregoing embodiments. Details are not described herein again.

In some embodiments, as shown in FIG. 16, the gap 132 is formed between the peripheral side surface 213b of the second plate body 21b of the reinforcing plate 2 and the side wall 131 of the groove 13. In this embodiment, the gap 132 between the peripheral side surface 213b of the second plate body 21b and the side wall 131 of the groove 13 is an assembly gap. Disposing the assembly gap can reduce a risk of damage caused by the reinforcing plate 2 to the display screen 1, to protect the display screen 1.

In some embodiments, as shown in FIG. 16 and FIG. 17, the reinforcing plate 2 further includes the light barrier layer 23, and the light barrier layer 23 is annular. The light barrier layer 23 is fastened to a periphery of a surface that is of the first plate body 21a and that is away from the second plate body 21b. For example, the first plate body 21a further includes a second plate surface 212a, and the second plate surface 212a is disposed away from the first plate surface 211a. The light barrier layer 23 is fastened to a periphery of the second plate surface 212a, and a middle part of the second plate surface 212a is exposed. The periphery of the second plate surface 212a and the middle part of the second plate surface 212a are two regions of the second plate surface 212a, and the periphery of the second plate surface 212a is disposed around the middle part of the second plate surface 212a. There is a relative location relationship between the middle part and the periphery. However, how to locate a boundary between the middle part and the periphery is not strictly limited in embodiments of this application. For example, in a radial direction of the second plate surface 212a, a width of the periphery of the second plate surface 212a may be greater than, equal to, or less than a width of the middle of the second plate surface 212a.

For example, in the thickness direction Z of the display 10, the light barrier layer 23 covers the gap 132 and a periphery of the second plate body 21b. The light barrier layer 23 may be made of a light absorbing material or a light blocking material to block an optical path. For example, the light barrier layer 23 may be an ink layer, and the ink layer may be formed by directly coating ink on the second plate surface 212a. Alternatively, the light barrier layer 23 may be a black film, and the black film may be fastened to the second plate surface 212a through bonding or the like.

In this embodiment, the light barrier layer 23 shields the gap 132 between the reinforcing plate 2 and the side wall 131 of the groove 13, and the periphery of the second plate body 21b, so that appearance effect of the display 10 can be improved. In addition, the light barrier layer 23 can further absorb stray light, to reduce stray light entering a lighting path of the optical device 30, so as to improve lighting quality of the optical device 30. The stray light may be, but is not limited to, light emitted by the display screen 1, or light emitted by a component like a flash in the electronic device 100.

In addition, the second plate surface 212a of the first plate body 21a is close to the non-display side of the display 10, and is accordingly close to the optical device 30 located on the non-display side of the display 10. Therefore, a distance between the light barrier layer 23 located on the second plate surface 212a and the optical device 30 is small, and a size of an inner diameter of the light barrier layer 23 may be set to a small size based on a light-receiving field of view characteristic of the optical device 30, so that a size of an outer diameter of the light barrier layer 23 may be small, a size of an outer diameter of the reinforcing plate 2 may be small, and an opening size of the groove 13 of the display screen 1 may be small. This helps increase a screen-to-body ratio of the display 10.

Compared with the solution in which the display screen 1 is provided with the light shielding layer 14 in the embodiment in FIG. 5, in this embodiment, the display screen 1 may not be provided with the light shielding layer. This simplifies a manufacturing process of the display screen 1, and reduces costs of the display screen 1. Except for no provision of the light shielding layer 14, for the rest of the structure of the display screen 1, refer to related descriptions in the foregoing embodiments. Details are not described herein again. In addition, a display region (not marked in the figure) of the display screen 1 is disposed based on the second screen part 12, and a light shielding region (not marked in the figure) is a region between the display region and the light transmission region 10a.

In some embodiments, as shown in FIG. 16 to FIG. 18, the reinforcing plate 2 further includes the light blocking layer 22, and the light blocking layer 22 covers at least a region that is on the peripheral side surface 213b of the second plate body 21b and that is located in the groove 13. For example, the light blocking layer 22 may cover the peripheral side surface 213b of the second plate body 21b. The light blocking layer 22 may be made of a light absorbing material or a light blocking material, to block an optical path. For example, the light blocking layer 22 may be an ink layer, and the ink layer may be formed by directly coating ink on the peripheral side surface 213b of the second plate body 21b. Alternatively, the light blocking layer 22 may be a black film, and the black film may be fastened to the peripheral side surface 213b of the second plate body 21b through bonding or the like.

In this embodiment, the light blocking layer 22 of the reinforcing plate 2 is disposed facing the side wall 131 of the groove 13. The light blocking layer 22 may absorb stray light or block propagation of stray light, to reduce stray light entering a lighting path of the optical device 30, and reduce a risk of light crosstalk, so as to improve lighting quality of the optical device 30. The stray light may be, but is not limited to, light emitted by the display screen 1, or light emitted by a component like a flash in the electronic device 100.

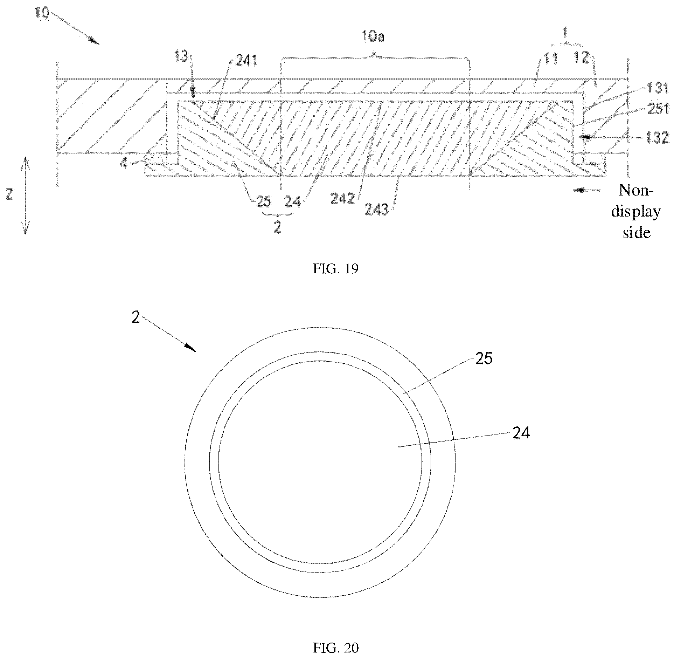

FIG. 19 is a partial diagram of an internal structure of the display 10 of the electronic device 100 shown in FIG. 1 according to some other embodiments. FIG. 20 is a diagram of a structure of the reinforcing plate 2 shown in FIG. 19 from another perspective. The display 10 in the embodiment of FIG. 19 may include most technical features of the display 10 in the foregoing embodiment. The following mainly describes a difference between the two, and a same part between the two is not described again.

In some embodiments, as shown in FIG. 19 and FIG. 20, the reinforcing plate 2 may include a light transmission part 24 and a light shielding part 25, and a transmittance of the light transmission part 24 is higher than a transmittance of the light shielding part 25. The light transmission part 24 is configured to allow external light to pass through, and the light shielding part 25 is configured to block external light. The light shielding part 25 is disposed around the light transmission part 24 and is fastened to a peripheral side surface 241 of the light transmission part 24. For example, the light transmission part 24 may be in a shape of an inverted platform. For example, the light transmission part 24 includes a first surface 242 and a second surface 243 that are disposed back to back, and the peripheral side surface 241 of the light transmission part 24 is connected to the first surface 242 and the second surface 243. The first surface 242 faces the first screen part 11, the second surface 243 is away from the first screen part 11, and an area of the first surface 242 is greater than that of the second surface 243. In some other embodiments, the light transmission part 24 may alternatively be cylindrical. This is not strictly limited in embodiments of this application.

The transmittance of the light shielding part 25 may be less than 20%, and the transmittance of the light transmission part 24 may be greater than or equal to 20%. The light shielding part 25 and the light transmission part 24 may be an integrally formed mechanical part, for example, may be formed by using a process like dual-color injection molding.

The reinforcing plate 2 is partially located in the groove 13 of the display screen 1, and partially located outside the groove 13. The light shielding part 25 of the reinforcing plate 2 has a peripheral side surface 251 facing the side wall 131 of the groove 13, and the gap 132 is formed between the peripheral side surface 251 of the light shielding part 25 and the side wall 131 of the groove 13. In the thickness direction Z of the display 10, the light shielding part 25 covers the gap 132. A part that is of the light shielding part 25 and that is located outside the groove 13 is fastened to the second screen part 12 of the display screen 1. For example, a flange part of the light shielding part 25 may be bonded to the second screen part 12 through the adhesive layer 4.

In this embodiment, the light transmission region 10a of the display 10 is disposed corresponding to the first screen part 11 and the light transmission part 24 of the reinforcing plate 2, and has a high transmittance. The optical device 30 (not shown in the figure) on the non-display side of the display 10 can collect external light through the light transmission region 10a. The reinforcing plate 2 may increase structural strength of the first screen part 11 and a surrounding location of the first screen part 11, so that reliability of the display 10 is higher. In addition, relative locations of the light shielding part 25 and the light transmission part 24 of the reinforcing plate 2 may be set based on a light-receiving field of view characteristic of the optical device 30, so that the optical device 30 has a small size that meets a lighting requirement of the optical device 30. This helps reduce an opening size of the groove 13 of the display screen 1, and helps increase a screen-to-body ratio of the display 10.

In some embodiments, the light shielding part 25 may absorb stray light or block propagation of the stray light, to reduce stray light entering a lighting path of the optical device 30, and improve lighting quality of the optical device 30.

In some other embodiments of this application, when a depth of the groove 13 of the display screen 1 is small, the reinforcing plate 2 may alternatively be completely located outside rather than in the groove 13. A periphery of the reinforcing plate 2 is fastened to the second screen part 12, and a middle part of the reinforcing plate 2 covers the groove 13. In this case, when the first screen part 11 is externally pressed or impacted, the reinforcing plate 2 may also support the first screen part 11, to reduce a risk of damage to the first screen part 11, and reduce a risk of damage to the optical device 30 through the first screen part 11.

The following describes, by using an example, an implementation of an assembly structure of the display 10, the housing 20, and the optical device 30 of the electronic device 100.

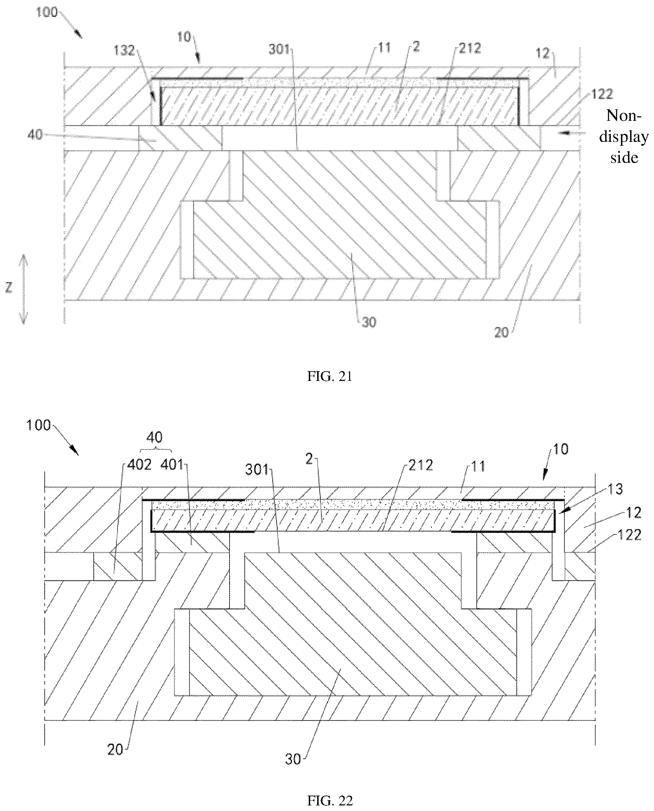

FIG. 21 is a diagram of a cross-sectional structure of the electronic device 100 shown in FIG. 1 cut along C-C according to some embodiments. The display 10 in FIG. 21 is illustrated by using the display 10 in the embodiment in FIG. 5 as an example.

In some embodiments, as shown in FIG. 5 and FIG. 21, the optical device 30 of the electronic device 100 is mounted on the housing 20, and is located on the non-display side of the display 10. For example, the optical device 30 may be located on a side that is of the reinforcing plate 2 of the display 10 and that is away from the first screen part 11. The optical device 30 is configured to collect external light that passes through the first screen part 11 and the reinforcing plate 2. For example, the optical device 30 may be a camera module, and the camera module collects external light that passes through the light transmission region 10a of the display 10, to implement image shooting.

In this embodiment, the light transmission region 10a of the display 10 has a high transmittance. Therefore, imaging quality of the camera module is high. The reinforcing plate 2 of the display 10 increases structural strength of the first screen part 11. So when the first screen part 11 is externally pressed or impacted, there is a low risk of deformation or damage, and the optical device 30 has a lower risk of damage, so that reliability of the electronic device 100 is improved.

In some embodiments, as shown in FIG. 21, the electronic device 100 may further include a support member 40, and the support member 40 abuts between the reinforcing plate 2 and the housing 20. External light enters the optical device 30 through an incident surface 301 of the optical device 30.

In this embodiment, because the support member 40 abuts between the reinforcing plate 2 and the housing 20, the housing 20 may indirectly support the reinforcing plate 2 through the support member 40, to support the first screen part 11, so that the first screen part 11 has a lower risk of deformation or damage when externally pressed or impacted. In this way, the display 10 and the electronic device 100 achieve higher reliability.

The support member 40 may be made of an elastic material, to have a supporting and buffering function. For example, the support member 40 may be made of a material like foam, glue, or an adhesive tape. In this case, the support member 40 may further absorb an assembly tolerance between the display 10 and the housing 20 in an assembly process of the electronic device 100, to improve a yield of the electronic device 100. A thickness of the support member 40 may be within a range of 0.1 mm (mm) to 0.2 mm.

The support member 40 may be disposed around the incident surface 301 of the optical device 30. The support member 40 may be approximately annular. In this embodiment, because the support member 40 is disposed around the incident surface 301 of the optical device 30, disposing of the support member 40 does not affect lighting of the optical device 30. In addition, a support region of the support member 40 for the reinforcing plate 2 is annular, and the support region is arranged evenly on a periphery of the reinforcing plate 2, so that the reinforcing plate 2 is not prone to problems such as tilting and warping. In this way, the first screen part 11 can be reinforced, and consistency of an optical path of the light transmission region 10a of the display 10 can be ensured.

For example, the support member 40 is connected to the reinforcing plate 2 and the housing 20 through sealing. In this case, the support member 40 can seal a gap between the housing 20 and the reinforcing plate 2, to seal a gap between the optical device 30 and the reinforcing plate 2, so as to reduce a risk that dust falls into the incident surface 301 of the optical device 30, and achieve a dust-proof effect.

For example, the support member 40 may further abut between the second screen part 12 and the housing 20. In this case, the housing 20 may indirectly support the second screen part 12 through the support member 40, to further reduce the risk of deformation or damage of the display 10 when externally pressed or impacted. In this way, reliability of the display 10 and the electronic device 100 is higher.

For example, the support member 40 may include two parts, where one part abuts between the reinforcing plate 2 and the housing 20, and the other part abuts between the second screen part 12 and the housing 20. The two parts may be connected to each other, or may be independent of each other. In some other embodiments, the support member 40 may not include the part that abuts between the reinforcing plate 2 and the housing 20. In this case, the part that abuts between the second screen part 12 and the housing 20 may be disposed around the incident surface 301 of the optical device 30, and is connected to the second screen part 12 and the housing 20 through sealing, to achieve a dust-proof effect of the optical device 30.

In the foregoing embodiment, the support member 40 is a continuous mechanical part. In some other embodiments, the support member 40 may alternatively include a plurality of independent parts, and the plurality of parts are spaced from each other around the incident surface 301 of the optical device 30. A specific structure and a specific arrangement location of the support member 40 are not strictly limited in embodiments of this application.

When the second plate surface 212 of the reinforcing plate 2 is flush with the second inner surface 122 of the second screen part 12, it is easier to implement an assembly structure of the display 10, the support member 40, and the housing 20 with high assembly precision and low difficulty.

In some other embodiments, the support member 40 may be made of a light absorbing material or a light blocking material. In the thickness direction Z of the display 10, the support member 40 covers the gap 132 between the reinforcing plate 2 and the side wall 131 of the groove 13 and the periphery of the reinforcing plate 2. In this case, the display screen 1 may not be provided with the light shielding layer 14.

FIG. 22 is a diagram of a cross-sectional structure of the electronic device 100 shown in FIG. 1 cut along C-C according to some other embodiments. The electronic device 100 in the embodiment of FIG. 22 may include most technical features of the electronic device 100 in the foregoing embodiment. The following mainly describes a difference between the two, and a same part between the two is not described again. The display 10 in FIG. 22 is illustrated by using the display 10 in the embodiment in FIG. 15 as an example.

In some embodiments, the second plate surface 212 of the reinforcing plate 2 is recessed relative to the second inner surface 122 of the second screen part 12, and a distance between the optical device 30 and the first screen part 11 is reduced. When a location of the optical device 30 is a bottleneck of an overall thickness of the electronic device 100, because the distance between the optical device 30 and the first screen part 11 is small, the overall thickness of the electronic device 100 can be effectively controlled. This facilitates thinning of the electronic device 100.

For example, the support member 40 includes a first part 401 and a second part 402. The first part 401 abuts between the reinforcing plate 2 and the housing 20, and the second part 402 abuts between the second screen part 12 and the housing 20. The first part 401 surrounds the incident surface 301 of the optical device 30, and is connected to the reinforcing plate 2 and the housing 20 through sealing; and/or the second part 402 surrounds the incident surface 301 of the optical device 30, and is connected to the second screen part 12 and the housing 20 through sealing. The first part 401 may be at least partially located in the groove 13 of the display screen 1, and the second part 402 is located outside the groove 13. For another design of the support member 40, refer to the foregoing embodiment. Details are not described herein again.

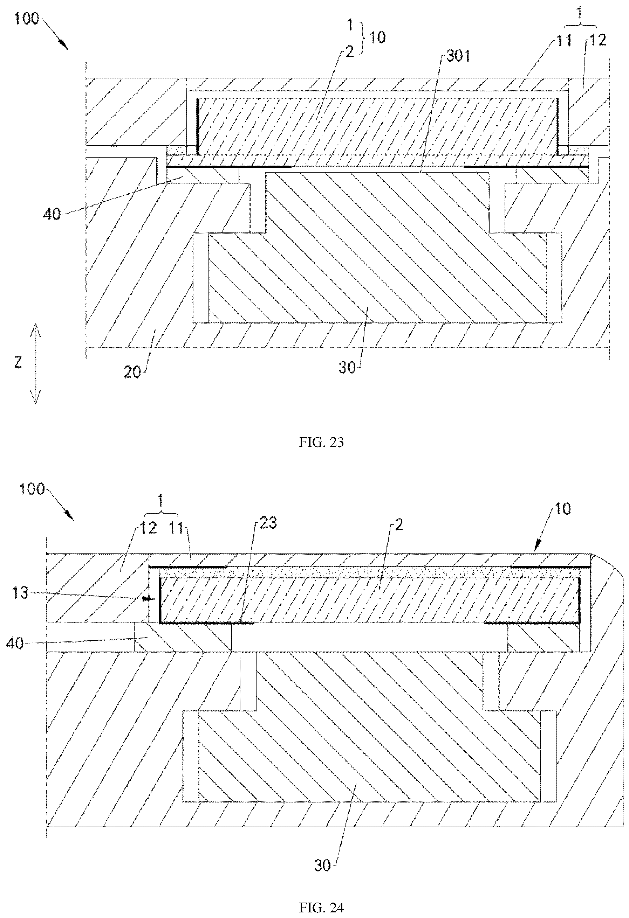

FIG. 23 is a diagram of a cross-sectional structure of the electronic device 100 shown in FIG. 1 cut along C-C according to some other embodiments. The electronic device 100 in the embodiment of FIG. 23 may include most technical features of the electronic device 100 in the foregoing embodiment. The following mainly describes a difference between the two, and a same part between the two is not described again. The display 10 in FIG. 23 is illustrated by using the display 10 in the embodiment in FIG. 16 as an example.

In some embodiments, the support member 40 abuts between the reinforcing plate 2 and the housing 20. The support member 40 may be disposed around the incident surface 301 of the optical device 30. The support member 40 may be connected to the reinforcing plate 2 and the housing 20 through sealing.

In this embodiment, because the reinforcing plate 2 is directly connected to the second screen part 12 of the display screen 1, and the support member 40 supports a periphery of the reinforcing plate 2, when the first screen part 11 or the second screen part 12 of the display screen 1 is subject to force or impact, the reinforcing plate 2, the support member 40, and the housing 20 can all provide stable and reliable support, to improve reliability of the display 10.

In the thickness direction Z of the display 10, there may be an overlapping region among the second screen part 12, the reinforcing plate 2, and the support member 40, so that a structure for supporting the display 10 by the housing 20 is more reliable.

In some other embodiments, the housing 20 has high precision, there may be no gap or a small gap between the housing 20 and the reinforcing plate 2, and there may be no gap or a small gap between the housing 20 and a part that is of the second screen part 12 and that is close to the groove 13. In this case, the electronic device 100 may not be provided with the foregoing support member 40, and the housing 20 may support the reinforcing plate 2 and the second screen part 12.

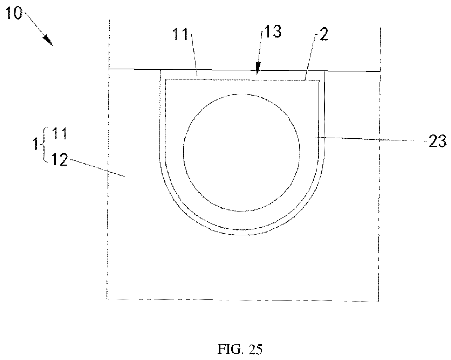

FIG. 24 is a diagram of a cross-sectional structure of the electronic device 100 shown in FIG. 1 cut along C-C according to some other embodiments. FIG. 25 is a diagram of a structure of the display 10 shown in FIG. 24 from another perspective. The electronic device 100 in the embodiment of FIG. 24 may include most technical features of the electronic device 100 in the foregoing embodiment. The following mainly describes a difference between the two, and a same part between the two is not described again.

In some embodiments, as shown in FIG. 24 and FIG. 25, the second screen part 12 of the display screen 1 may half surround the first screen part 11. In this case, the first screen part 11 and the groove 13 of the display screen 1 are located at an edge of the display screen 1, and one side of the groove 13 is open. In this case, a shape of the reinforcing plate 2 may adaptively change based on a shape of the groove 13. The light barrier layer 23 may be disposed on a plate surface that is of the reinforcing plate 2 and that faces the optical device 30. For another structural design of the reinforcing plate 2, refer to the embodiment in FIG. 14, FIG. 15, or FIG. 16.

In this embodiment, because the light barrier layer 23 is disposed on the plate surface that is of the reinforcing plate 2 and that faces the optical device 30, a distance between the light barrier layer 23 and the optical device 30 is small, a size of an inner diameter of the light barrier layer 23 may be set to a small size, a size of an outer diameter of the light barrier layer 23 may be small, a size of an outer diameter of the reinforcing plate 2 may be small, and an opening size of the groove 13 of the display screen 1 may be small. This helps increase a screen-to-body ratio of the display 10, and helps reduce a width of an entire frame of the electronic device 100, to improve aesthetics of the entire electronic device 100.

The support member 40 may abut between the reinforcing plate 2 and the housing 20. The support member 40 may be disposed around the incident surface 301 of the optical device 30. The support member 40 may be connected to the reinforcing plate 2 and the housing 20 through sealing. The support member 40 may further be connected between the second screen part 12 of the display screen 1 and the housing 20.

It may be understood that, in the display 10 in the embodiments of FIG. 4 to FIG. 20, a solution in which the second screen part 12 of the display screen 1 surrounds the first screen part 11 may change to a solution in which the second screen part 12 of the display screen 1 half surrounds the first screen part 11, and the structure of the reinforcing plate 2 and a fitting structure of the reinforcing plate 2 and the display screen 1 remain unchanged or adaptively change, to form some other embodiment solutions of this application. Details are not described herein.

The display 10 in the foregoing embodiments of this application may be used in a foldable electronic device, or may be used in a non-foldable electronic device, for example, a bar-type device or a slidable device. The display 10 may change a form in a use process of the electronic device, or may be presented in a fixed form. This is not strictly limited in embodiments of this application.

All the foregoing accompanying drawings are examples of this application. The accompanying drawings mainly show parts of a product related to an implementation of this application. The product may still include another part that is not shown in the accompanying drawings. In addition, actual shapes, actual locations, actual sizes and proportions, actual structures, an actual quantity, and the like of components or structures of the product are not limited by the accompanying drawings.

The foregoing implementations are intended for describing the technical solutions of this application, but not for limiting this application. Although this application is described in detail with reference to the foregoing implementations, a person of ordinary skilled in the art should understand that modifications may still be made to the technical solutions described in the foregoing implementations or equivalent replacements may be made to some technical features, and such modifications or replacements do not cause the essence of the corresponding technical solutions to depart from the scope of the technical solutions of implementations of this application.

Implementations of this application or features in implementations may be combined with each other if there is no conflict, and any combination of features in different implementations also falls within the protection scope of this application. In other words, the plurality of implementations described above may alternatively be combined according to an actual requirement.

## Claims

1. A display, comprising a display screen and a reinforcing plate, wherein
the display screen comprises a first screen part and a second screen part, the second screen part fully or half surrounds the first screen part, the first screen part comprises a first outer surface and a first inner surface that are disposed back to back, the second screen part comprises a second outer surface and a second inner surface that are disposed back to back, the first outer surface is flush with the second outer surface, and the first inner surface is recessed relative to the second inner surface to form a groove;
the reinforcing plate is located on a side that is of the first inner surface and that is away from the first outer surface, the reinforcing plate and the first screen part are stacked, and the reinforcing plate is at least partially located in the groove and is fastened to the display screen; and
at least a partial region of the first screen part allows external light to pass through, and at least a partial region of the reinforcing plate allows external light to pass through; and external light is capable of passing through the first screen part and the reinforcing plate and entering non-display side space of the display.

2. The display according to claim 1, wherein the display screen comprises a first stack layer and a second stack layer, the first stack layer is located on the first screen part and the second screen part, the second stack layer is located on the second screen part, and a transmittance of the first stack layer is higher than a transmittance of the second stack layer.

3. The display according to claim 2, wherein a transmittance of the reinforcing plate is higher than the transmittance of the second stack layer.

4. The display according to any one of claims 1 to 3, wherein in a plane direction of the display, an opening area of the groove is a first area, a part that is of the reinforcing plate and that is located in the groove has a second area, and a ratio of the second area to the first area is greater than or equal to 80%.

5. The display according to any one of claims 1 to 4, wherein the display further comprises a bonding member, the bonding member is located between the reinforcing plate and the first inner surface and is fastened to the reinforcing plate and the first inner surface, and the bonding member allows external light to pass through.

6. The display according to claim 5, wherein a surface that is of the second screen part and that faces the groove is a side wall of the groove, and a gap is formed between a peripheral side surface of the reinforcing plate and the side wall of the groove; and
the display screen comprises a light shielding layer, the light shielding layer is annular, the light shielding layer is at least partially located on the first screen part, and in a thickness direction of the display, the light shielding layer covers the gap and a periphery of the reinforcing plate, and exposes a middle part of the reinforcing plate.

7. The display according to claim 6, wherein the reinforcing plate comprises a plate body and a light barrier layer, a transmittance of the plate body is greater than or equal to 20%, and the light barrier layer is fastened to a plate surface that is of the plate body and that is away from the first screen part; and
the light barrier layer is annular, an inner diameter of the light barrier layer is less than an inner diameter of the light shielding layer, an outer diameter of the light barrier layer is greater than the inner diameter of the light shielding layer, and intra-annular space of the light barrier layer is directly opposite to intra-annular space of the light shielding layer.

8. The display according to any one of claims 5 to 7, wherein the reinforcing plate comprises the plate body and a light blocking layer, and the light blocking layer covers a peripheral side surface of the plate body.

9. The display according to any one of claims 5 to 8, wherein in the thickness direction of the display, a sum of a thickness of the reinforcing plate and a thickness of the bonding member is equal to or less than a depth of the groove.

10. The display according to any one of claims 1 to 4, wherein the reinforcing plate comprises a first plate body and a second plate body, the second plate body is fastened to a middle part of the first plate body, and a transmittance of the first plate body and a transmittance of the second plate body are both greater than or equal to 20%; and
the second plate body is at least partially located in the groove, the first plate body is located outside the groove, and a periphery of the first plate body is fastened to the second screen part.

11. The display according to claim 10, wherein a surface that is of the second screen part and that faces the groove is a side wall of the groove, and a gap is formed between a peripheral side surface of the second plate body and the side wall of the groove; and
the reinforcing plate further comprises a light barrier layer, wherein the light barrier layer is annular, the light barrier layer is fastened to a periphery of a surface that is of the first plate body and that is away from the second plate body, and in a thickness direction of the display, the light barrier layer covers the gap and a periphery of the second plate body.

12. The display according to claim 10 or 11, wherein the reinforcing plate further comprises a light blocking layer, and the light blocking layer covers at least a region that is on the peripheral side surface of the second plate body and that is located in the groove.

13. An electronic device, comprising a housing, an optical device, and the display according to any one of claims 1 to 12, wherein the display is mounted on the housing, the optical device is mounted on the housing and is located on the non-display side of the display, and the optical device is configured to collect external light that passes through the first screen part and the reinforcing plate.

14. The electronic device according to claim 13, wherein the electronic device further comprises a support member, and the support member abuts between the reinforcing plate and the housing.

15. The electronic device according to claim 14, wherein the support member is disposed around a collection surface of the optical device, and the support member is connected to the reinforcing plate and the housing through sealing.
